# EUROPEAN PATENT SPECIFICATION

(11) **EP 1 837 180 B1**
(45) Date of publication and mention of the grant of the patent: **26.01.2011**
(21) Application number: 07004490.4
(22) Date of filing: 05.03.2007
(51) Int. Cl.: B41J 2/16

(54) **Method for producing piezoelectric actuator, ink-jet head, and ink-jet printer using aerosol deposition method, piezoelectric actuator, ink-jet head, and ink-jet printer**
Verfahren zur Herstellung eines piezoelektrischen Aktors, Tintenstrahlkopf und Tintenstrahldrucker mit Aerosolablagerungsverfahren, piezoelektrischer Aktor, Tintenstrahlkopf und Tintenstrahldrucker
Procédé de fabrication d'un actionneur piézo-électrique, tête à jet d'encre, et imprimante à jet d'encre utilisant un procédé de dépôt d'aérosol, actionneur piézo-électrique et imprimante à jet d'encre

(30) Priority: 20.03.2006 JP 2006075942
(43) Date of publication of application: 26.09.2007
(73) Proprietor: Brother Kogyo Kabushiki Kaisha, Nagoya-shi, Aichi-ken 467-8561 (JP)
(72) Inventor: Sugahara, Hiroto, Nagoya-shi Aichi-ken 467-8562 (JP); Yasui, Motohiro, Nagoya-shi Aichi-ken 467-8562 (JP)
(74) Representative: Kuhnen & Wacker

(56) References cited:
- EP-A- 1 617 491
- JP-A- 2005 317 952
- US-A1- 2005 068 378
- US-A1- 2005 211 162
- US-A1- 2005 231 073

## Description

### BACKGROUND OF THE INVENTION

### Field of the Invention

The present invention relates to a technique for producing an ink-jet head having a piezoelectric actuator.

### Description of the Related Art

Some of ink-jet heads jetting ink from a jetting nozzle include a piezoelectric actuator, formed by using a ferroelectric, piezoelectric ceramic material such as lead zirconate titanate (PZT), as an actuator applying a jetting pressure to the ink. A general piezoelectric actuator used for an ink-jet head includes a substrate (also called a vibration plate) which covers pressure chambers storing the ink; a piezoelectric material layer formed in a thin film form on one surface of the substrate; and electrodes generating an electric field in a thickness direction of the piezoelectric material layer; and the actuator is constructed to deform the substrate by utilizing the deformation of the piezoelectric material layer when the electric field is generated, thereby applying a pressure to the ink in the pressure chambers.

As one of the methods for forming a thin film on a flat surface of a substrate, there has been conventionally known an aerosol deposition method (hereinafter, referred to as AD method) in which aerosol, containing a thin film material in a fine particulate form and a carrier gas, is jetted from a film-forming nozzle toward the substrate, and by collision energy generated at this time, the particles are deposited on the surface of the substrate to form a film. Japanese Patent Application Laid-open No. 2004-122341 discloses a method for forming a piezoelectric material layer of a piezoelectric actuator or the like in a thin film form on a surface of a substrate by using the AD method. According to this method, while a film-forming nozzle having a slit is moved relative to the substrate, aerosol containing particles of a piezoelectric material and a carrier gas is sprayed (jetted, blown) from the slit to the surface of the substrate to deposit the particles of the piezoelectric material on the substrate, thereby forming a piezoelectric material layer in a thin film form on the substrate.

In a general method for forming a thin film layer on a substrate by the AD method is to jet aerosol while moving a film-forming nozzle relative to the substrate in a predetermined direction. In this case, the thin film layer formed on the substrate has substantially uniform thickness in a movement direction in which the film-forming nozzle is moved. However, thickness distribution easily occurs in the thin film layer in a direction (width direction) perpendicular to the movement direction of the film-forming nozzle (See Fig. 10 of Japanese Patent Application Laid-open No. 2004-122341). One of the reasons for this is that a deposition speed at which the particles are deposited varies in the width direction of the formed thin film layer having a band-shape because the aerosol jetted from the slit is distributed in a non-uniform manner. Another reason is that the aerosol jetted at a predetermined angle from the slit shaves off a portion of the film previously formed on the substrate, resulting in a delayed deposition of the particles on an area with the shaven portion.

In a piezoelectric actuator for ink-jet head, if a piezoelectric material layer has thickness distribution, the intensity of an electric field generated in the piezoelectric material layer and rigidity of the piezoelectric material layer vary depending on places. This causes variation in pressure applied to inks and consequently causes variation in droplet-jetting characteristics (droplet velocity, droplet volume, and the like) among a plurality of jetting nozzles jetting droplets, which in some case greatly lowers quality of images and the like recorded on a recording medium (printing quality).

### SUMMARY OF THE INVENTION

It is an object of the present invention to provide a piezoelectric actuator, an ink-jet head including the same, and an ink-jet printer, which are capable of suppressing, as much as possible, deterioration in printing quality which would be otherwise caused by thickness distribution, even if a thin film layer formed on a substrate by an AD method has the thickness distribution.

The object is achieved by the invention as defined by the appended claims.

According to a first aspect of the present invention, there is provided a method for producing an ink-jet head including a channel unit having a plurality of pressure chambers each of which extends in a predetermined direction and which are arranged along a plane, and a plurality of jetting nozzles which communicate with the pressure chambers respectively and which jet an ink onto a recording medium; and a piezoelectric actuator having a substrate disposed on one surface of the channel unit to cover the pressure chambers, and a plurality of thin film layers disposed on one surface of the substrate, the thin film layers including a piezoelectric material layer, the method including: a step for forming the thin film layers of the piezoelectric actuator on the substrate; and a step for attaching the channel unit to the substrate; wherein in the step for forming the thin film layers, at least one thin film layer among the thin film layers is formed by jetting aerosol, which contains particles forming the thin film layer and a carrier gas, from a slit formed in a film-forming nozzle while moving the film-forming nozzle having the slit relative to the substrate in a direction which is a width direction of the slit and is a direction intersecting with the predetermined direction.

Upon jetting the aerosol with the film-forming nozzle having a slit extending in a certain direction, when the film-forming nozzle jets the aerosol while being moved relative to the substrate in the width direction (which is perpendicular to the certain direction) of the slit of the nozzle, then the thin film layer formed on the substrate easily has thickness distribution in a direction perpendicular to the relative-movement direction of the nozzle, that is, the width direction of the nozzle. However, in this producing method, the relative-movement direction of the film-forming nozzle when the aerosol is jetted intersects with the predetermined direction in which the pressure chambers extend (that is, a movement direction of the recording medium relative to the ink-jet head at the time of recording). Therefore, an arrangement direction of a plurality of dots formed on the recording medium by the jetting nozzles is different from the direction in which the thickness distribution occurs in the thin film layer. Therefore, the influence that the thickness distribution of the thin film layer has on variation in size of the dots formed on the recording medium is small, and banding caused due to the variation in size of the dots becomes less conspicuous. That is, deterioration in printing quality caused by the banding is prevented.

In the method for producing the ink-jet head of the present invention, the direction intersecting with the predetermined direction may be a direction perpendicular to the predetermined direction. Alternatively, the slit of the film-forming nozzle may have a slit-length to an extent that a jetting area formed by the aerosol jetted from the slit to the substrate covers at least one of the pressure chambers.

In the method for producing the ink-jet head of the present invention, the direction intersecting with the predetermined direction may be a direction perpendicular to a relative-movement direction in which the recording medium is moved relative to the ink-jet head upon performing recording using the ink-jet head. In this case, since the relative-movement direction of the film-forming nozzle is perpendicular to the relative-movement direction in which the produced ink-jet head is moved relative to the recording medium, the influence that the thickness distribution of the thin film layer has on variation in size of dots formed on the recording medium is further lessened, and the deterioration in printing quality caused by banding is assuredly prevented.

In the method for producing the ink-jet head of the present invention, the jetting nozzles may be arranged to form, on the recording medium, a plurality of dots arranged in an arrangement direction at an equal spacing distance; and a relative-movement direction in which the film-forming nozzle is moved relative to the substrate may be the arrangement direction of the dots. In this case, since the direction in which thickness distribution occurs in the thin film layer is different from the arrangement direction of the dots formed on the recording medium by the jetting nozzles, the deterioration in printing quality due to banding is prevented.

In the method for producing the ink-jet head of the present invention, the jetting nozzles may be arranged at least in an arrangement direction; and a relative-movement direction in which the film-forming nozzle is moved relative to the substrate may be the arrangement direction in which the jetting nozzles are arranged. In this case, since the direction of the thickness distribution of the thin film layer is different from the arrangement direction of dots formed on the recording medium by the jetting nozzles, the deterioration in printing quality due to banding is prevented.

In the method for producing the ink-jet head of the present invention, the jetting nozzles may be arranged in a matrix form in a first arrangement direction and a second arrangement direction intersecting with the first arrangement direction; and the relative-movement direction in which the film-forming nozzle is moved relative to the substrate may be an arrangement direction same as one of the first and second arrangement directions, in which jetting nozzles among the jetting nozzles are arranged in a number greater than that of jetting nozzles arranged in the other of the first and second arrangement directions. In a case in which the jetting nozzles are arranged in two different directions, one arrangement direction in which jetting nozzles are arranged in a number greater than those arranged in the other arrangement direction often corresponds to the arrangement direction of the dots formed on the recording medium. Therefore, by making the relative-movement direction of the film-forming nozzle relative to the substrate parallel to the arrangement direction in which a larger number of the jetting nozzles are arranged, the deterioration in printing quality due to banding is prevented.

In the method for producing the ink-jet head of the present invention, in the aerosol jetting, the aerosol may be jetted to a plurality of jetting areas, of the substrate, arranged in a relative-movement direction in which the recording medium is moved relative to the ink-jet head while the film-forming nozzle is moved relative to each of the jetting areas. With this structure, since the aerosol is jetted from the film-forming nozzle to each of the plural jetting areas, it is possible to form the thin film layer over a wide area of the substrate.

In the method for producing the ink-jet head of the present invention, in the aerosol jetting, the piezoelectric material layers may be formed by jetting the aerosol which contains particles of a piezoelectric material and a carrier gas, from the slit of the film-forming nozzle to the substrate. When the piezoelectric material layer has thickness distribution, the difference in its thickness causes pressure applied to the ink in the pressure chambers vary among the pressure chambers, thereby also changing the size of dots formed on the recording medium by the jetting nozzles corresponding to the pressure chambers respectively. However, according to this producing method, since the direction in which the thickness distribution occurs in the piezoelectric material layers is different from the arrangement direction of the dots formed on the recording medium by the jetting nozzles, the deterioration in printing quality due to banding is prevented as much as possible.

In the method for producing the ink-jet head of the present invention, the piezoelectric material layer may be formed on the substrate on the other surface thereof on a side opposite to the channel unit. According to this producing method, since the piezoelectric material layer is positioned opposite to the pressure chambers of the channel unit, it is possible to obtain a piezoelectric actuator having structure in which the piezoelectric material layer has no contact with the ink.

In the method for producing the ink-jet head of the present invention, the ink-j et head may be a serial-type ink-j et head which jets the ink from the jetting nozzles onto the recording medium transported in a transporting direction perpendicular to a predetermined scanning direction, while moving in the scanning direction; and a relative-movement direction in which the film-forming nozzle is moved relative to the substrate may be the transporting direction in which the recording medium is transported. When the ink-jet head is a serial-type ink-jet head, the arrangement direction of dots formed on the recording medium by the jetting nozzles at the time of the scanning by the head is the same as (parallel to) the feeding (transporting) direction in which the recording medium is transported. Further, according to this producing method, since the relative-movement direction of the film-forming nozzle is the transporting direction of the recording medium, the direction in which the thickness distribution occurs in the thin film layer is different from the arrangement direction of dots, and therefore, the deterioration in printing quality due to banding is assuredly prevented.

In the method for producing the ink-jet head of the present invention, the ink-jet head may be a line-type ink-jet head having the jetting nozzles arranged at an equal spacing distance in an arrangement direction perpendicular to a transporting direction in which the recording medium is transported; and the relative-movement direction in which the film-forming nozzle is moved relative to the substrate may be the arrangement direction of the jetting nozzles. When the ink-jet head is a line-type head, the arrangement direction of dots formed on the recording medium by the jetting nozzles is often parallel to the arrangement direction of the jetting nozzles. According to this producing method, since the relative-movement direction of the film-forming nozzle is parallel to the arrangement direction of the jetting nozzles, the direction in which thickness distribution occurs in the thin film layer is different from the arrangement direction of the dots, and therefore, the deterioration in printing quality due to banding is assuredly prevented.

According to a second aspect of the present invention, there is provided a method for producing an ink-jet printer including an ink-jet head which is provided with a channel unit having a plurality of pressure chambers, and a plurality of jetting nozzles which communicate with the pressure chambers respectively and which jet an ink onto a recording medium; and a piezoelectric actuator having a substrate disposed on the channel unit to cover the pressure chambers, and a plurality of thin film layers disposed on one surface of the substrate, the thin film layers including a piezoelectric material layer; and a moving unit which moves the ink-jet head relative to the recording medium in a relative-movement direction; the method including: a step for producing the ink-jet head by forming the thin film layers of the piezoelectric actuator on the substrate and attaching the channel unit to the substrate; and a step for providing the moving unit; wherein in forming the thin film layers, at least one thin film layer among the thin film layers is formed by jetting aerosol, which contains particles forming the thin film layer and a carrier gas, from a slit formed in a film-forming nozzle while moving the film-forming nozzle having the slit relative to the substrate in a direction which is a width direction of the slit and is a direction intersecting with the relative-movement direction.

According to this method for producing the ink-jet printer, the relative-movement direction of the film-forming nozzle at the time of the aerosol jetting is not same as (parallel to) the direction in which the ink-jet head is moved relative to the recording medium, and these two directions intersect with each other. Consequently, the arrangement direction of dots formed on the recording medium by the jetting nozzles is different from the direction in which thickness distribution occurs in the thin film layer. Therefore, the deterioration in printing quality due to banding is prevented as much as possible.

In the method for producing the ink-jet printer of the present invention, the ink-jet head may include a plurality of heads which jet a plurality of different color inks respectively. According to this producing method, all the thin film layers of the piezoelectric actuators of the plural ink-j et heads are formed in a same process. Therefore, degrees of variation in size of dots are equal among the ink-jet heads, and thus the size of the dots does not change among the color inks.

According to a third aspect of the present invention, there is provided a method for producing a piezoelectric actuator which has a substrate and a plurality of thin film layers disposed on the substrate, the thin film layers including a piezoelectric material layer, and in which a plurality of active portions extending in a predetermined direction are defined in the piezoelectric material layer, the method including: a step for forming the piezoelectric material layer on the substrate; and a step for forming another thin film layer other than the piezoelectric material layer on the substrate; wherein at least one thin film layer among the thin film layers is formed by jetting aerosol, which contains particles forming the thin film layer and a carrier gas, from a slit formed in a film-forming nozzle, while moving the film-forming nozzle having the slit relative to the substrate in a direction which is a width direction of the slit and is a direction intersecting with the predetermined direction.

According to this method for producing the piezoelectric actuator, since the relative-movement direction of the film-forming nozzle upon jetting the aerosol intersects with the direction in which the active portions extend (that is, a relative-movement direction in which an ink-jet head including the piezoelectric actuator is moved relative to a recording medium), the arrangement direction of dots formed on the recording medium by the plurality of jetting nozzles is different from a direction in which thickness distribution occurs in the thin film layer. Therefore, when the piezoelectric actuator is used in the ink-jet head, deterioration in printing quality due to banding is prevented as much as possible.

In the method for producing the piezoelectric actuator of the present invention, the at least one thin film layer may be the piezoelectric material layer. Accordingly, it is possible to solve any problem due to difference in droplet amount jetted by the active portions, which is caused by thickness distribution in the active portions. The thin film layers may include a metal plate and an insulation layer; and the at least one thin film layer may be the insulation layer. The active portions may be portions, of the piezoelectric material layer, sandwiched between electrodes.

According to a fourth aspect of the present invention, there is provided an ink-jet head which jets an ink, including: a channel unit having a plurality of pressure chambers each of which extends in a predetermined direction and which are arranged along a plane, and a plurality of jetting nozzles which communicate with the pressure chambers respectively and which jet the ink; and a piezoelectric actuator having a substrate disposed on one surface of the channel unit to cover the pressure chambers, and a plurality of thin film layers disposed on one surface of the substrate, the thin film layers including a piezoelectric material layer; wherein in at least one thin film layer, among the thin film layers, thickness uniformity of the thin film layer in a direction intersecting with the predetermined direction is higher than thickness uniformity of the thin film layer in a direction perpendicular to the intersecting direction.

According to the ink-jet head of the present invention, since in at least one thin film layer among the thin film layers, thickness uniformity of the thin film layer in the direction intersecting with the predetermined direction (that is, a relative-movement direction in which a recording medium is moved relative to the ink-jet head, for example, a scanning direction in a case of a serial-type ink-jet head, and a paper feeding direction in a case of a line-type ink-jet head) is higher than thickness uniformity of the thin film layer in the direction perpendicular to the intersecting direction.
Therefore, deterioration in printing quality due to banding is prevented.

In the ink-jet head of the present invention, the at least one thin film layer may be formed by jetting aerosol, which contains particles forming the thin film layer and a carrier gas, from a slit formed in a film-forming nozzle while moving the film-forming nozzle having the slit relative to the substrate in a direction which is a width direction of the slit and is the direction intersecting with the predetermined direction. If the thin film layer is produced in this manner, the arrangement direction of dots formed on the recording medium by the jetting nozzles is different from a direction in which thickness distribution occurs the thin film layer. Therefore, deterioration in printing quality due to banding is prevented.

According to a fifth aspect of the present invention, there is provided an ink-jet printer including: an ink-jet head which includes: a channel unit having a plurality of pressure chambers and a plurality of jetting nozzles which communicate with the pressure chambers respectively and which jet an ink onto a recording medium; and a piezoelectric actuator having a substrate disposed on the channel unit to cover the pressure chambers, and a plurality of thin film layers disposed on one surface of the substrate, the thin film layers including a piezoelectric material layer; and a moving unit which moves the ink-jet head relative to the recording medium in a relative-movement direction; wherein in at least one thin film layer, among the thin film layers, thickness uniformity of the thin film layer in a direction intersecting with the relative-movement direction is higher than thickness uniformity of the thin film layer in a direction perpendicular to the intersecting direction.

According to the ink-jet printer of the present invention, in the at least one thin film layer among the thin film layers, thickness uniformity of the thin film layer in the relative-movement direction which is, for example, the scanning direction in a case of a serial-type ink-jet head and a paper feeding direction in a case of a line-type ink-jet printer is higher than thickness uniformity of the thin film layer in the direction perpendicular to the intersecting direction.
Therefore, deterioration in printing quality due to banding is prevented.

In the ink-jet printer of the present invention, the at least one thin film layer may be formed by jetting aerosol, which contains particles forming the thin film layer and a carrier gas, from a slit formed in a film-forming nozzle while moving the film-forming nozzle having the slit relative to the substrate in a direction which is a width direction of the slit and is a direction intersecting with the relative-movement direction. Accordingly, the arrangement direction of dots formed on the recording medium by the jetting nozzles is different from a direction in which thickness direction occurs in the thin film layer. Therefore, deterioration in printing quality due to banding is prevented.

According to a sixth aspect of the present invention, there is provided a piezoelectric actuator which is used to jet a liquid, including: a substrate; and a plurality of thin film layers which include a piezoelectric material layer and which are disposed on the substrate; wherein a plurality of active portions extending in a predetermined direction are defined in the piezoelectric material layer; and in at least one thin film layer among the thin film layers, thickness uniformity of the thin film layer in a direction intersecting with the predetermined direction is higher than thickness uniformity of the thin film layer in a direction perpendicular to the intersecting direction.

According to the piezoelectric actuator of the present invention, in at least one thin film layer among the thin film layers, thickness uniformity of the thin film layer in the direction interesting with the direction in which the active portions extend which is, for example, a scanning direction in a case in which the piezoelectric actuator is used in a serial-type ink-jet head and a paper feeding direction in a case in which the piezoelectric actuator is used in a line-type ink-jet head, is higher than thickness uniformity of the thin film layer in the direction perpendicular to the intersecting direction. Therefore, deterioration in printing quality due to banding is prevented.

In the piezoelectric actuator of the present invention, the at least one thin film layer may be formed by jetting aerosol, which contains particles forming the thin film layer and a carrier gas, from a slit formed in a film-forming nozzle while moving the film-forming nozzle having the slit relative to the substrate in a direction which is a width direction of the slit and is the direction intersecting with the predetermined direction, in particular, in a direction perpendicular to the predetermined direction. By forming the thin film layer in this manner, the arrangement direction of dots formed on the recording medium by the jetting nozzles is different from a direction in which thickness distribution occurs in the thin film layer. Therefore, deterioration in printing quality due to banding is prevented as much as possible.

### BRIEF DESCRIPTION OF THE DRAWINGS

Fig. 1 is a schematic structural view of an ink-jet printer according to an embodiment of the present invention;
Fig. 2 is a plan view of an ink-jet head;
Fig. 3 is a partial enlarged view of Fig. 2;
Fig. 4 is a cross-sectional view taken along IV-IV line in Fig. 3;
Fig. 5 is a cross-sectional view taken along V-V line in Fig. 3;
Figs. 6A to 6C are explanatory views of producing steps of the ink-jet head;
Fig. 7 is a schematic structural view of a film-forming apparatus;
Fig. 8A is a view showing a positional relationship between a vibration plate and a film-forming nozzle in a certain area of the vibration plate when a piezoelectric material layer is formed, Fig. 8B is a view showing a positional relationship between the vibration plate and the film-forming nozzle in another area of the vibration plate when a piezoelectric material layer is formed, and Fig. 8C is a view showing a relationship between a jet-area and active portions;
Figs. 9A to 9C are views showing a film-formation state of a piezoelectric material layer when the film-forming nozzle is relatively moved in a direction parallel to a scanning direction, Fig. 9A being a plan view of the ink-jet head, Fig. 9B being a side view of a piezoelectric actuator seen from the scanning direction, and Fig. 9C being a side view of the piezoelectric actuator seen from a paper feeding direction;
Fig. 10 is a plan view of the ink-jet head having the piezoelectric material layer formed by the film-forming step in Figs. 9A to 9C, and is a view showing dots formed on a recording paper by the ink-jet head;
Figs. 11A to 11C are views showing a film-formation state of a piezoelectric material layer when the film-forming nozzle is relatively moved in a direction parallel to the paper feeding direction, Fig. 11A being a plan view of the ink-jet head, Fig. 11B being a side view of the piezoelectric actuator seen from the scanning direction, and Fig. 11C being a side view of the piezoelectric actuator seen from the paper feeding direction;
Fig. 12A is a plan view of the ink-jet head having the piezoelectric material layer formed by the film-forming step of Figs. 11A to 11C and is a view showing dots formed on a recording paper by the ink-jet head, and Fig. 12B is a side view of the piezoelectric actuator seen from the paper feeding direction;
Figs. 13A to 13C are views showing a film-formation state of a piezoelectric material layer of a first modification, Fig. 13A being a plan view of an ink-jet head, Fig. 13B being a side view of a piezoelectric actuator seen from the scanning direction, and Fig. 13C being a side view of the piezoelectric actuator seen from the paper feeding direction;
Fig. 14 is a plan view of an ink-jet head of a second modification;
Figs. 15A to 15C are views showing a film-formation state of a piezoelectric material layer of a third modification, Fig. 15A being a plan view of a piezoelectric actuator (ink-jet head), Fig. 15B being a side view of the piezoelectric actuator seen from the scanning direction, and Fig. 15C being a side view of the piezoelectric actuator seen from the paper feeding direction;
Fig. 16 is a plan view of an ink-jet head of a fourth modification;
Fig. 17 is a plan view of an ink-jet head of a fifth modification;
Fig. 18 is a cross-sectional view of an ink-jet head of a sixth modification, corresponding to Fig. 4;
Fig. 19 is a cross-sectional view of an ink-jet head of a seventh modification, corresponding to Fig. 4;
Fig. 20 is a plan view of a line-type ink-jet head of a eighth modification; and
Fig. 21A is a plan view of an ink-jet head having a piezoelectric material layer formed by a film-forming nozzle relatively moving in a direction parallel to the scanning direction, and Fig. 21B is a side view of a piezoelectric actuator seen from the scanning direction.

### DETAILED DESCRIPTION OF THE PREFERRED EMBODIMENTS

Next, an embodiment of the present invention will be explained. This embodiment is an example in which the present invention is applied to a serial-type ink-j et head which records an image and/or the like by jetting an ink onto a recording paper while moving in one direction.

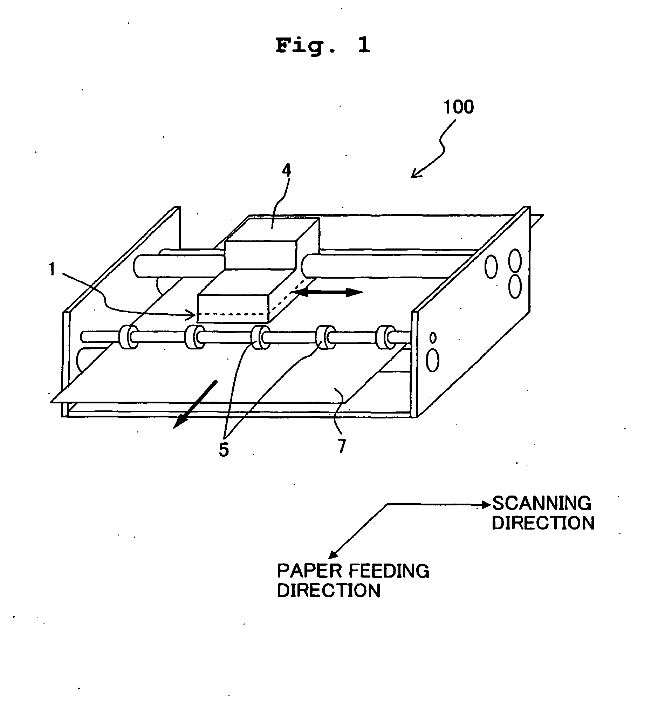

First, the construction of an ink-jet printer including the serial-type ink-jet head will be briefly explained. As shown in Fig. 1, an ink-jet printer 100 includes a carriage 4 (moving unit) movable in a right and left direction in Fig. 1; a serial-type ink-jet head 1 provided in the carriage 4 to jet an ink to a recording paper 7; transporting rollers 5 transporting (feeding) the recording paper 7 in a forward direction in Fig. 1; and the like. Note that Fig. 1 shows only one ink-jet head 1, but actually, four ink-jet heads 1 jetting inks of four colors (cyan, magenta, yellow, black) respectively are provided in the carriage 4. That is, the ink-jet printer 100 is a color ink-jet printer capable of recording a color image on the recording paper 7.

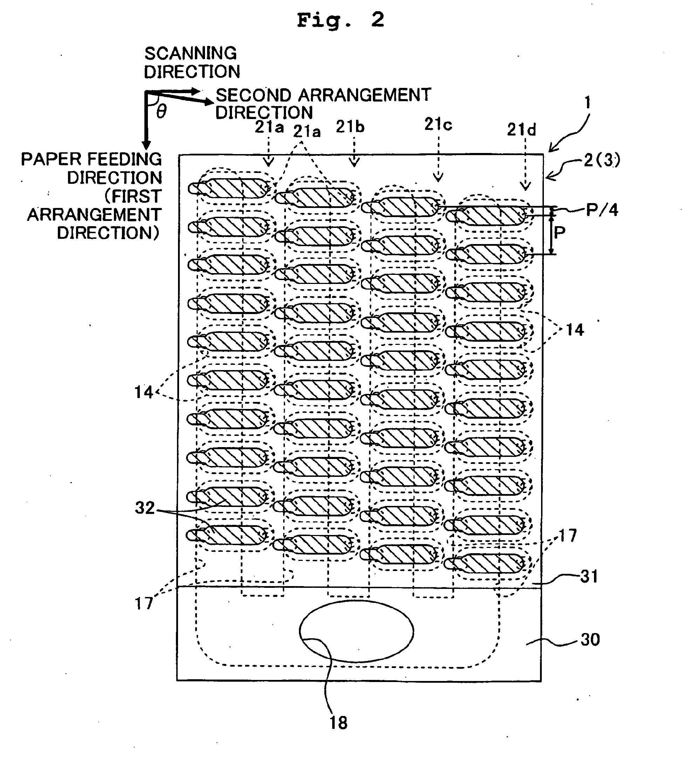

The ink-jet printer 100 is capable of recording a desired character, color image, and/or the like on the recording paper 7 by alternately performing an operation in which the four color inks are jetted onto the recording paper 7 from jetting nozzles 20 (see Fig. 2 to Fig. 5) formed on a lower surface of the carriage 4 while the four ink-jet heads 1 move integrally with the carriage 4 in the right and left direction (scanning direction) and a paper transporting operation in which the transporting roller 5 feed the recording paper 7 forward by a predetermined amount.

Next, the ink-jet head 1 will be explained with reference to Fig. 2 to Fig. 5. The ink-jet head 1 includes: a channel unit 2 in which an ink channel including the jetting nozzles 20 and pressure chambers 14 are formed therein; and a piezoelectric actuator 3 which is disposed on the upper surface of the channel unit 2 to apply a jetting pressure to an ink in the pressure chambers 14.

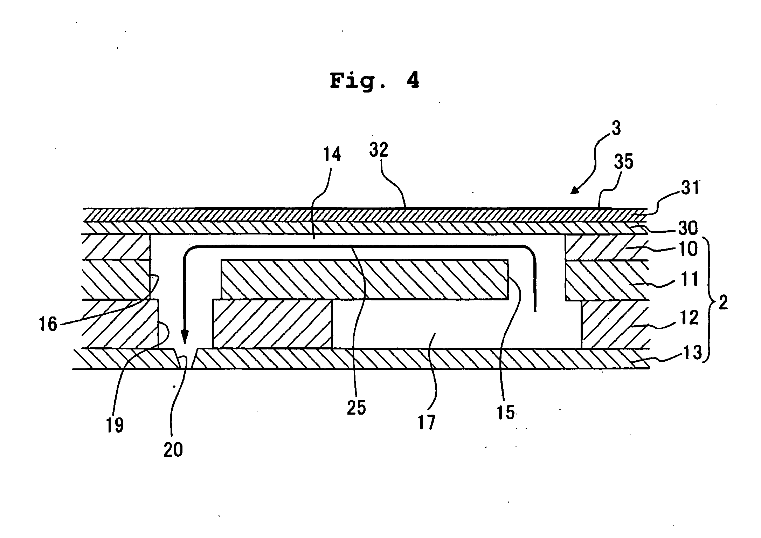

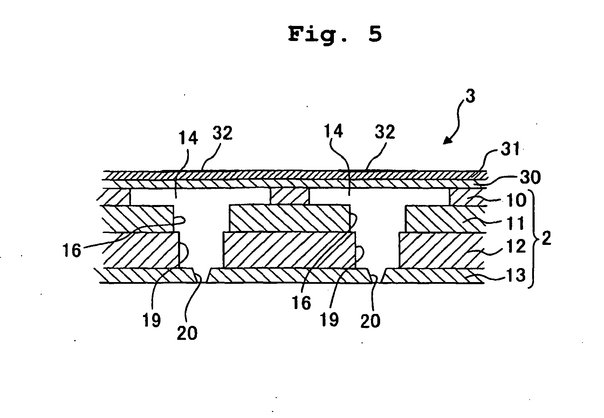

First, the channel unit 2 will be explained. As shown in Fig. 4 and Fig. 5, the channel unit 2 includes a cavity plate 10, a base plate 11, a manifold plate 12, and a nozzle plate 13, and these four plates 10 to 13 are joined together in a stacked state. Among these plates, the cavity plate 10, the base plate 11, and the manifold plate 12 are stainless steel plates, and the ink channel such as manifolds 17 (to be described later) and the pressure chambers 14 can be easily formed in these three plates 10 to 12 by etching. Further, the nozzle plate 13 is made of a synthetic high-molecular resin material such as polyimide or the like and is bonded on the lower surface of the manifold plate 12. Alternatively, this nozzle plate 13 may also be formed of a metal material such as stainless steel similarly to the three plates 10 to 12.

As shown in Fig. 2 to Fig. 5, in the uppermost cavity plate 10 among the four plates 10 to 13, the pressure chambers 14 each of which extends in the scanning direction (predetermined direction) and which are arranged along a plane are formed of holes penetrating the plate 10, and these pressure chambers 14 are covered by a vibration plate 30 (to be described later) and the base plate 11 from upper and lower sides respectively. Further, the pressure chambers 14 are arranged in four rows aligned in a paper feeding direction (up and down direction in Fig. 2). Further, each of the pressure chambers 14 has a substantially elliptical form which is long in the scanning direction (right and left direction in Fig. 2) in a plan view.

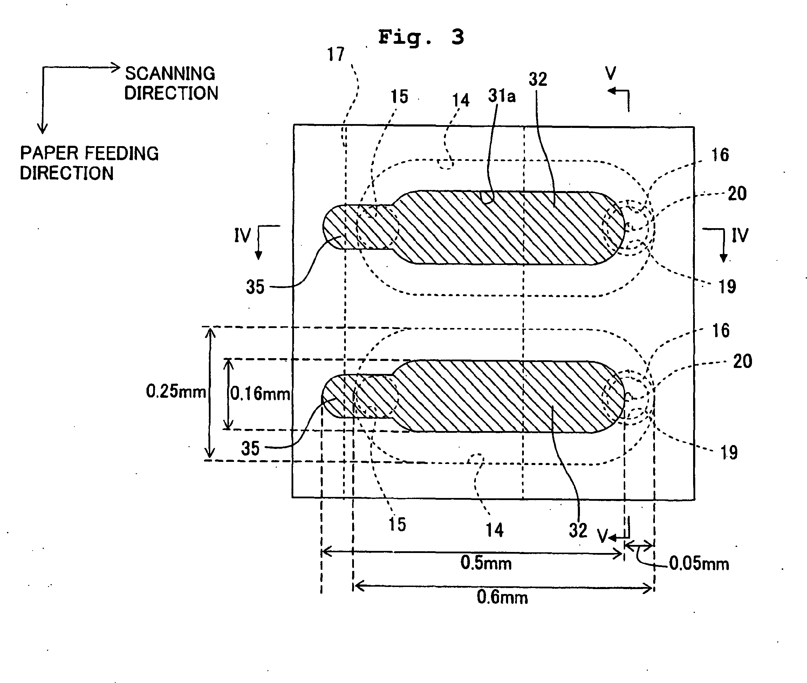

As shown in Fig. 3, in the base plate 11, communication holes 15, 16 are formed respectively at positions overlapping in a plan view with both end portions of each of the pressure chambers 14. Further, in the manifold plate 12, four manifolds 17 extending in the paper feeding direction (up and down direction in Fig. 2) are formed to overlap in a plan view with portions of the pressure chambers 14 arranged in the paper feeding direction, each of the portions being on a side of communication hole 15. These four manifolds 17 communicate with an ink supply port 18 formed in the vibration plate 30 (to be described later), and inks are supplied to the manifolds 17 via the ink supply port 18 from an ink tank (not shown). In the manifold plate 12, a plurality of communication holes 19 communicating with the communication holes 16 respectively are also formed at positions each overlapping in a plan view with an end portion, of one of the pressure chambers 14, on a side opposite to the manifold 17.

Further, in the nozzle plate 13, a plurality of jetting nozzles 20 are formed at positions overlapping in a plan view with the communication holes 19 respectively. As shown in Fig. 2, each of the jetting nozzles 20 overlaps with an end portion of one of the pressure chambers 14 arranged in four rows, on a side opposite to the manifold 17, and the nozzles 20 are arranged in the paper feeding direction (up and down direction in Fig. 2) at an equal spacing distance in areas overlapping with none of the four manifolds 17 to form four nozzle rows 21a, 21b, 21c, 21d arranged in the scanning direction. These four nozzle rows 21a to 21d are constructed of a same number of the jetting nozzles 20, spacing distances (pitches P) between the jetting nozzles 20 in the arrangement direction are equal among these nozzle rows 21a to 21d. Further, the four nozzle rows 21a to 21d are shifted in sequence by a value of quarter of P (P/4) toward the downstream in the paper feeding direction (downward in Fig. 2). Therefore, with the four nozzle rows 21a to 21d, it is possible to form, on the recording paper 7, a plurality of dots arranged at a spacing distance of P/4 in the paper feeding direction.

Note that, as shown in Fig. 2, the jetting nozzles 20 and the pressure chambers 14 corresponding to the jetting nozzles 20 are arranged not only in the paper feeding direction (first arrangement direction) but also in a direction intersecting with the paper feeding direction at an angle θ (second arrangement direction), and are consequently arranged in a matrix form in these two directions. Note that, however, the number of the jetting nozzles 10 and the pressure chambers 14 arranged in the first arrangement direction (ten) is larger than the number of those arranged in the second arrangement direction (four), and that the spacing distance in the first arrangement direction is smaller (arrangement density is higher) than that in the second arrangement direction. That is, the first arrangement direction corresponds to a direction in which rows of dots are formed on the recording paper 7 with higher (minute) definition.

As shown in Fig. 4, each of the manifolds 17 communicates with one of the pressure chambers 14 via one of the communication holes 15; and each of the pressure chambers 14 communicates with one of the jetting nozzles 20 via the communication holes 16, 19. In this manner, in the channel unit 2, a plurality of individual ink channels 25 are formed, each extending from one of the manifolds 17 to one of the jetting nozzles 20 via one of the pressure chambers 14.

Next, the piezoelectric actuator 3 will be described. As shown in Fig. 2 to Fig. 5, the piezoelectric actuator 3 has a metallic vibration plate 30 (substrate) disposed on the upper surface of the channel unit 2; a piezoelectric material layer 31 (piezoelectric material layer) continuously formed on the upper surface of the vibration plate 30 to cover the pressure chambers 14; and a plurality of individual electrodes 32 formed on the upper surface of the piezoelectric material layer 31 so as to correspond to the pressure chambers 14 respectively. The piezoelectric material layer 31 and the individual electrodes 32 are both layers in a thin film form (thin film layers) with a thickness of about several µm to about ten-odd µm.

The vibration plate 30 is a conductive plate made of a metal material and has a substantially rectangular shape in a plan view. The vibration plate 30 is made of, for example, an iron alloy such as stainless steel, a copper alloy, a nickel alloy, a titanium alloy, or the like. The vibration plate 30 is disposed on the upper surface of the cavity plate 10 to cover the pressure chambers 14 and is joined to the cavity plate 10. The vibration plate 30 is constantly kept at a ground potential and faces the individual electrodes 32, so that the vibration plate 30 also serves as a common electrode which causes an electric field in a thickness direction of the piezoelectric material layer 31 to act on the piezoelectric material layer 31 sandwiched between the individual electrodes 32 and the vibration plate 30.

On the upper surface of the vibration plate 30, formed is the piezoelectric material layer 31 which is mainly composed of lead zirconate titanate (PZT) which is a solid solution of lead titanate and lead zirconate and is a ferroelectric. The piezoelectric material layer 31 is formed continuously to cover the pressure chambers 14. Since the vibration plate 30 is disposed on the upper surface (surface opposite to the channel unit 2 (the pressure chambers 14)) of the vibration plate 30, the piezoelectric material layer 31 does not come into contact with the inks in the pressure chambers 14. The piezoelectric material layer 31 is formed by an AD method in which aerosol made of very fine particles and carrier gas is sprayed (blown) onto a substrate to deposit the particles on the substrate. This will be explained in detail later.

On the upper surface of the piezoelectric material layer 31, formed are the individual electrodes 32 each having a substantially elliptical plane shape which is a slightly smaller than one of the pressure chambers 14. These individual electrodes 32 are formed at positions overlapping in a plan view with center portions of the corresponding pressure chambers 14 respectively. The individual electrodes 32 are made of a conductive material such as gold, copper, silver, palladium, platinum, titanium, or the like. Further, a plurality of contact portions 35 are drawn from left end portions in Fig. 2 of the individual electrodes 32 respectively. Contact points of a flexible wiring member (not shown) such as a flexible printed circuit (FPC) are joined to the contact portions 35 respectively, and the contact portions 35 are electrically connected, via the wiring member, to a driver IC (not shown) which supplies a driving voltage selectively to the individual electrodes 32. In the piezoelectric material layer 31, areas 31a overlapping with the individual electrodes 32 respectively are areas deformable by the driving voltage as will be described later , and the areas 31a are referred to as "active portions". Fig. 3 shows an example of the dimension of the pressure chambers 14 (length: 0.6 mm, width: 0.25 mm) and the dimension of the active portion 14a and the individual electrode 32 (length: 0.5 mm, width: 0.16 mm) in the ink-jet head used in this example.

Next, the operation of the piezoelectric actuator 3 at the time when the ink is jetted will be explained. When the driver IC applies the driving voltage selectively to the individual electrodes 32, a certain individual electrode 32, among the individual electrodes 32, to which the driving voltage is applied and which is disposed above the piezoelectric material layer 31 becomes different in potential from the vibration plate 30 as the common electrode which is kept at the ground potential and which is disposed below the piezoelectric material layer 31. Consequently, an electric field in the thickness direction is generated in the piezoelectric material layer 31, especially in the active portion 31a sandwiched between the individual electrode 32 and the vibration plate 30. Here, in a case in which a polarization direction of the piezoelectric material layer 31 and the direction of the electric field are same, the piezoelectric material layer 31, in particular the active portion 31a thereof, expands in the thickness direction, which is its polarization direction and contracts in a horizontal direction. Then, since the vibration plate 30 is deformed to project toward the pressure chamber 14 accompanying with the contraction deformation of the piezoelectric material layer 31, the volume of the inside of a pressure chamber 14 corresponding to the individual electrode 32 decreases, and consequently, pressure is applied to the ink in the pressure chamber 14 to cause a jetting nozzle 20 communicating with the pressure chamber 14 to jet an droplet of the ink.

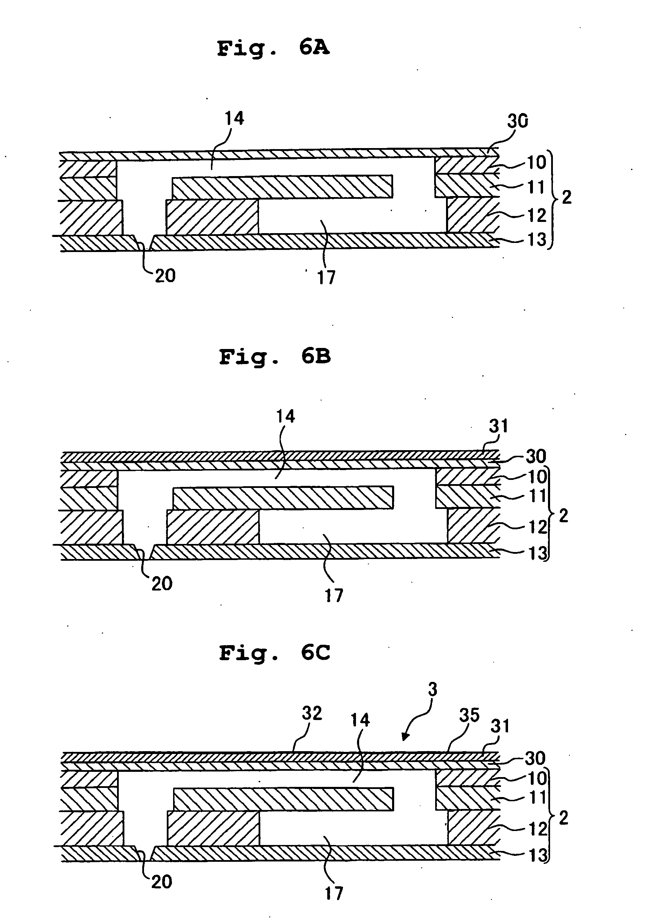

Next, a method for producing the ink-jet printer 100 will be explained, focusing on producing steps of the ink-jet head 1. Figs. 6A to 6C schematically show the producing steps of the ink-jet head 1. First, as shown in Fig. 6A, the four plates 10 to 13 constructing the channel unit 2 and the vibration plate 30 of the piezoelectric actuator 3 are joined together by adhesive bonding, metal diffusion bonding, or the like (step for attaching the channel unit).

Next, the piezoelectric actuator 3 is produced by the following steps. As shown in Fig. 6B, the piezoelectric material layer 31 is formed by the AD method on the upper surface (a surface opposite to the other surface at which the vibration plate 30 is joined to the channel unit 2) of the vibration plate 30. Namely, aerosol which contains ultra-fine particles of a piezoelectric material and a carrier gas is jetted toward the vibration plate 30 to make the particles collide against the vibration plate 30 at high speed so that the particles are highly densely deposited on the upper surface of the vibration plate 30, thereby forming the piezoelectric material layer 31 in a thin film form (step for forming thin film layers). Thereafter, as shown in Fig. 6C, the individual electrodes 32 and the contact portions 35 are formed on the upper surface of the piezoelectric material layer 31 by screen printing, a sputtering method, a deposition method, or the like.

In this way, the four ink-jet heads 1 jetting the four-color inks respectively are produced, the carriage 4 (moving unit) is provided, and these four ink-jet heads 1 are assembled in the carriage 4 (see Fig. 1). Then, various components such as the carriage 4 and the transporting rollers 5 are assembled in a frame (not shown) of a printer, thereby assembling the ink-jet printer 100.

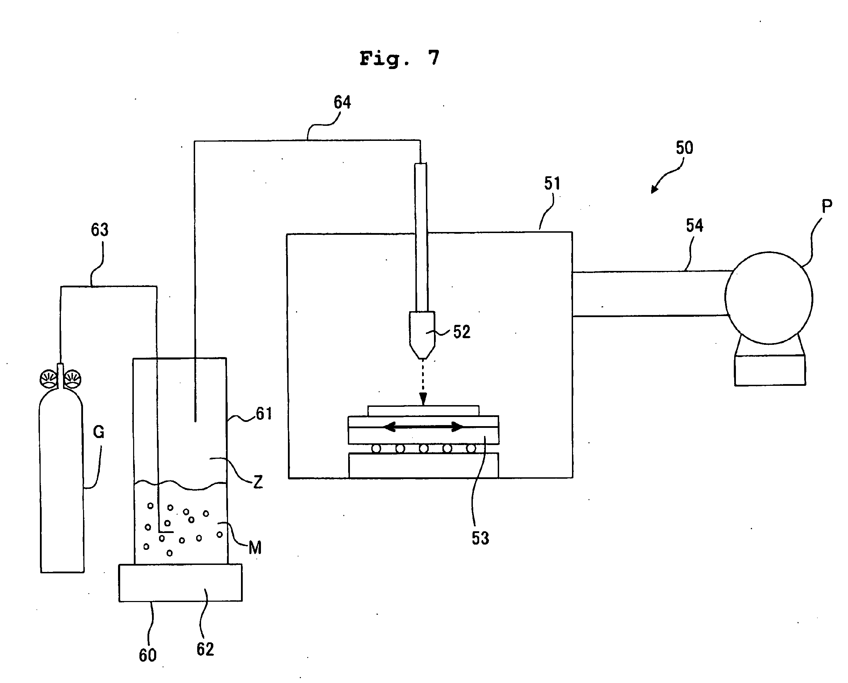

Among the producing steps of the ink-jet head 1 described above, the step for forming the piezoelectric material layer 31 by the AD method will be explained in more detail. Fig. 7 is a schematic structural view of a film-forming apparatus 50 for forming the piezoelectric material layer 31. The film-forming apparatus 50 includes a film-forming chamber 51, a film-forming nozzle 52 connected to an aerosol generator 60 via an aerosol supply pipe 64 and disposed in the film-forming chamber 51, and a stage 53 moving the vibration plate 30 in a predetermined direction in the film-forming chamber 51.

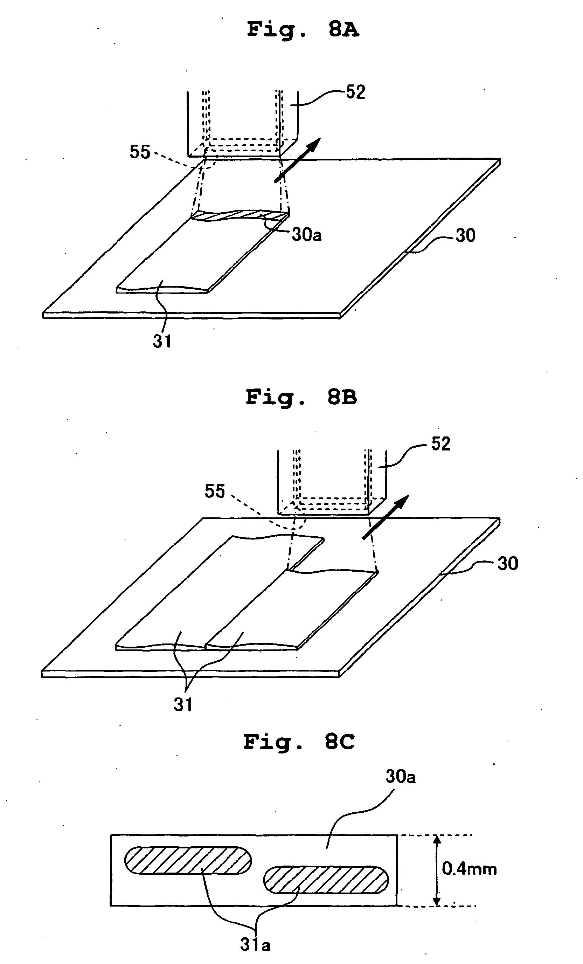

The aerosol generator 60 generates aerosol Z which is a mixture of a piezoelectric material in an ultra-fine particulate form (for example, particle size of not more than 1 µm) and a carrier gas. This aerosol generator 60 includes an aerosol chamber 61 which is capable of accommodating particulate material (material particles) M therein and a vibrating unit 62 which is attached to the aerosol chamber 61 to vibrate the aerosol chamber 61. A gas cylinder G for supplying the carrier gas is connected to the aerosol chamber 61 via an inlet pipe 63. As the carrier gas, used is dry air, nitrogen gas, argon gas, oxygen gas, helium gas, or the like. In the film-forming chamber 51, the film-forming nozzle 52 and the stage 53 are disposed, and the film-forming chamber 51 is further connected to a vacuum pump P via an exhaust pipe 54. The film-forming nozzle 52 has, in a tip portion thereof, a slit 55 (see Figs. 8A, 8B) which is open toward the vibration plate 30 on the stage 53 and which has a rectangular shape long in one direction. Further, the stage 53 moves the vibration plate 30 in a width direction (horizontal direction in Fig. 7) of the slit 55 of the film-forming nozzle 52.

In the film-forming apparatus 50, the pressure in the film-forming chamber 51 is lowered by the vacuum pump P, and the vibration plate 30 on the stage 53 is moved relative to the film-forming nozzle 52 while the aerosol generated in the aerosol generator 60 is jetted toward the upper surface of the vibration plate 30 from the slit 55 of the film-forming nozzle 52 (aerosol jetting step), thereby forming the piezoelectric material layer 31 on a predetermined area of the vibration plate 30.

The relative movement of the vibration plate 30 and the film-forming nozzle 52 when the piezoelectric material layer 31 is formed will be further explained in detail. Figs. 8A and 8B show the positional relationship between the vibration plate 30 and the film-forming nozzle 52 at the time of film formation. As described above, in practice, the vibration plate 30 moves together with the stage 53 relative to the film-forming nozzle 52. In the following explanation, however, for convenience sake, it is assumed that the film-forming nozzle 52 moves relative to the vibration plate 30.

As shown in Fig. 8A, the film-forming nozzle 52 jets the aerosol to the vibration plate 30 while moving, in the width direction of the slit 55, relative to a certain area of the upper surface of the vibration plate 30, thereby forming the piezoelectric material layer 31 on this area. In a case in which the piezoelectric material layer 31 needs to be formed on another area other than this area, as shown in Fig. 8B, the film-forming nozzle 52 jets the aerosol also to the another area while similarly moving in the width direction of the slit 55, thereby forming the piezoelectric material layer 31 also on the another area. Note that the jetting may be paused or stopped until the film-forming nozzle 52 reaches a position above the another area and then the jetting may be resumed when the film-forming nozzle 52 reaches a jetting start position for the another area. Fig. 8C shows an area 30a, on the substrate, covered by the aerosol jetted from the film-forming nozzle 52 in a paused state (hereinafter, referred to as a "jet-area"). In this example, the jet-area 30a is rectangular, has a width of about 0.4 mm, and has a length completely accommodating two pieces of the active portions 31a arranged in the scanning direction in the piezoelectric material layer 31. Note that the film-forming nozzle 52 which forms the jet-area 30a with a length covering one active portion 31a or not less than three pieces of the active portions 31a may be used. In this manner, by jetting the aerosol to a plurality of areas on the upper surface of the vibration plate 30 while moving the film-forming nozzle 52 relative to each of these areas, it is possible to form the piezoelectric material layer 31 over a wide area in the upper surface of the vibration plate 30.

Further, in forming the piezoelectric material layer 31, the film-forming nozzle 52 may be moved once relative to one area of the vibration plate 30, or the film-forming nozzle 52 may be moved a plurality of times relative to one area to deposit the particles of the piezoelectric material in multiple layers.

When the film-forming nozzle 52 which jets the aerosol is moved relative to the vibration plate 30 in the width direction of the slit 55 as shown in Figs. 8A and 8B to form the band-shaped piezoelectric material layer 31, then the band-shaped piezoelectric material layer 31 has a substantially uniform thickness in its longitudinal direction, namely, the movement direction (the front and back direction in Fig. 8A) of the film-forming nozzle 52. On the other hand, in the width direction of the band-shaped piezoelectric material layer 31 (direction perpendicular to the movement direction of the film-forming nozzle 52: the right and left direction in Fig. 8A) thickness distribution easily occurs in the piezoelectric material layer 31 because of a reason such as nonuniform velocity distribution of the aerosol jetted from the slit 55. If there is such a thickness distribution in the piezoelectric material layer 31, then intensity of the electric field generated in the piezoelectric material layer 31 and rigidity are varied depending on places, resulting in variation in deformation amount of the piezoelectric material layer 31 and the vibration plate 30. That is, droplet jetting characteristics such as the velocity and volume of the droplets jetted from the jetting nozzles 20 vary among the jetting nozzles 20.

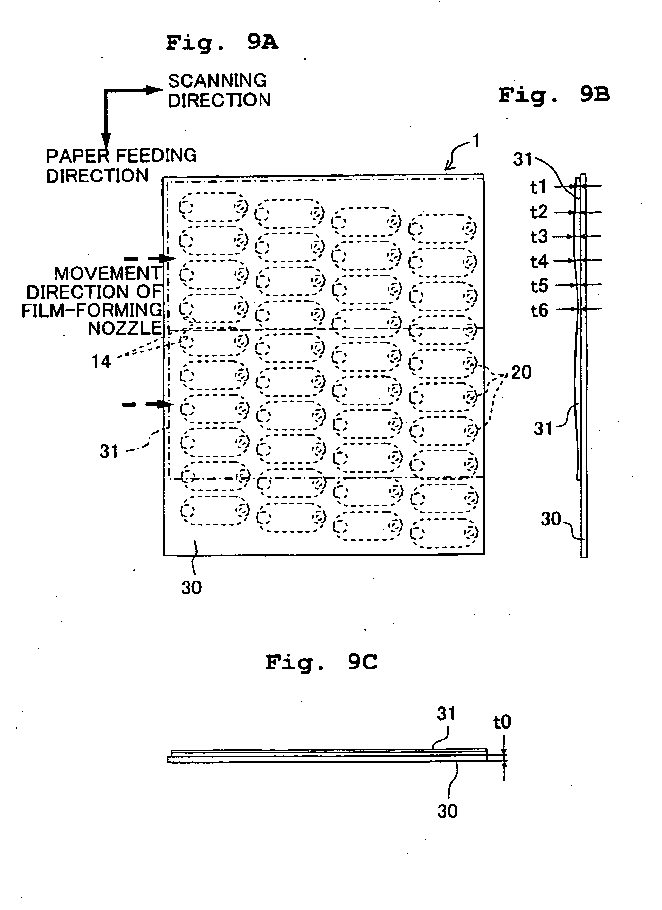

Here, the influence that the thickness distribution of the piezoelectric material layer 31 has on printing quality greatly differs depending on the direction in which the film-forming nozzle 52 moves relative to the vibration plate 30. For example, when it is assumed that the movement direction of the film-forming nozzle 52 upon forming the piezoelectric material layer 31 is a direction perpendicular to the arrangement direction of the jetting nozzles 20 (pressure chambers 14), namely a direction parallel to the scanning direction of the ink-jet head 1 as shown by broken-line arrows in Fig. 9A. In Fig. 9A, the individual electrodes 32 disposed on the upper surface of the piezoelectric material layer 31 are omitted. In this case, as shown in Fig. 9C, in the scanning direction of the ink-jet head 1 parallel to the movement direction of the film-forming nozzle 52, the thickness of the piezoelectric material layer 31 is substantially uniform. On the other hand, as shown in Fig. 9B, in the arrangement direction of the jetting nozzles 20 (pressure chambers 14) perpendicular to the movement direction of the film-forming nozzles 52, the piezoelectric material layer 31 has certain thickness distribution (t1 to t6).

At this time, if a same driving voltage is applied to the individual electrodes 32, a larger electric field acts on thin portions of the piezoelectric material layer 31 than that acting on thick portions. Further, rigidity of the thin portions is lower than the thick portions. Consequently, the thin portions are larger in deformation amount than the thick portions, and a high pressure is applied to the ink in the pressure chambers 14 corresponding to the thin portions. Accordingly, relatively large droplets are jetted from the jetting nozzles 20 corresponding to the thin portions of the piezoelectric material layer 31.

It is assumed, for example, that t0 = 15 µm (t0 is the thickness of the vibration plate 30), and the piezoelectric material layer 31 formed on the upper surface of the vibration plate 30 has a thickness distribution of t1 = 11 µm, t2 = 13 µm, t3 = 14 µm, t4 = 12 µm, t5 = 9 µm, and t6 = 10 µm as shown in Fig. 9B. In this case, the pressure applied to the inks in the pressure chambers 14 and the volume of the jetted ink droplets were obtained by numerical analysis. The analysis results are shown in Table 1.

**TABLE 1**

| Nozzle | Pressure (MPa) | Volume of liquid droplet (Pl) |
|---|---|---|
| A | 0.261 | 7.7 |
| B | 0.254 | 7.5 |
| C | 0.251 | 7.4 |
| D | 0.247 | 7.3 |
| E | 0.244 | 7.2 |
| F | 0.247 | 7.3 |
| G | 0.256 | 7.6 |
| H | 0.263 | 7.8 |
| I | 0.273 | 8.1 |
| J | 0.282 | 8.3 |
| K | 0.291 | 8.6 |
| L | 0.286 | 8.5 |
| M | 0.282 | 8.3 |
| N | 0.277 | 8.2 |
| O | 0.275 | 8.1 |
| P | 0.273 | 8.1 |

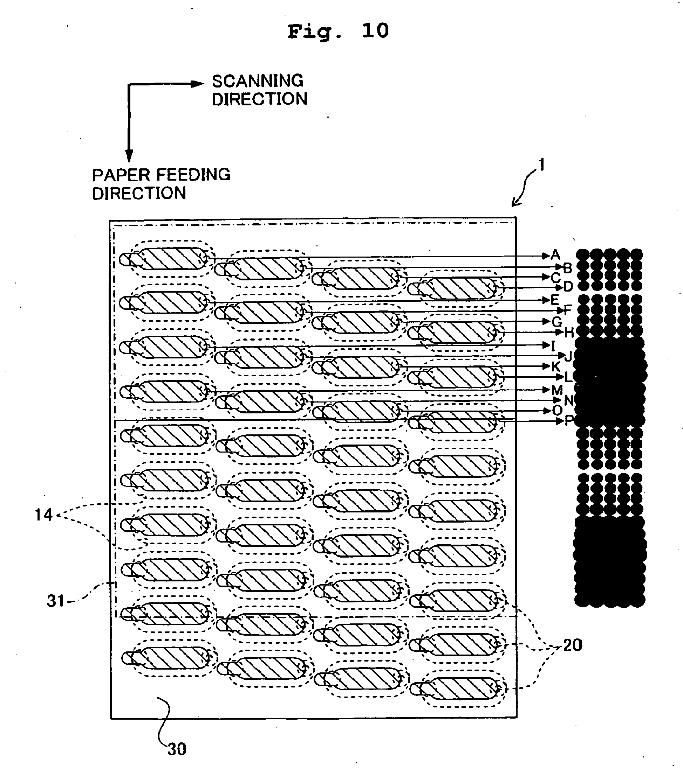

Nozzles A to P in Table 1 are 16 pieces of the jetting nozzles 20 arranged in sequence at a spacing distance of P/4 in the paper feeding direction in Fig. 10. Therefore, by these 16 jetting nozzles 20, 16 dots arranged at a spacing distance of P/4 in the paper feeding direction are formed on the recording paper 7. Note that t1 is a position of the nozzle A at an end of the pressure chamber on an upstream side in the paper feeding direction, and t1 to t6 represent positions apart from each other at a spacing distance of 0.25 µm. As shown in Table 1, volumes of droplets jetted from the 16 nozzles A to P change according to the thickness distribution of the piezoelectric material layer 31, and volumes of droplets jetted from the nozzles I to P corresponding to relatively thin portions are larger than those jetted from the nozzles A to H corresponding to relatively thick portions.

Further, the thickness of the piezoelectric material layer 31 changes continuously in the paper feeding direction, and according to the continuous thickness distribution, the size of the dots formed on the recording paper 7 by the nozzles A to P also changes continuously. Further, a group of relatively small dots formed by a nozzle group made of the nozzles A to H and a group of relatively large dots formed by a nozzle group made of the nozzles I to P are alternately arranged in the paper feeding direction. Therefore, the size of the dots formed on the recording paper 7 changes continuously over a long span (spacing distance between the nozzles A to P) in the paper feeding direction. Such a change in dot size results in uneven shading (banding) distinctly recognizable by eyes when a large number of dot rows are arranged in the scanning direction, resulting in greatly deteriorating the printing quality.

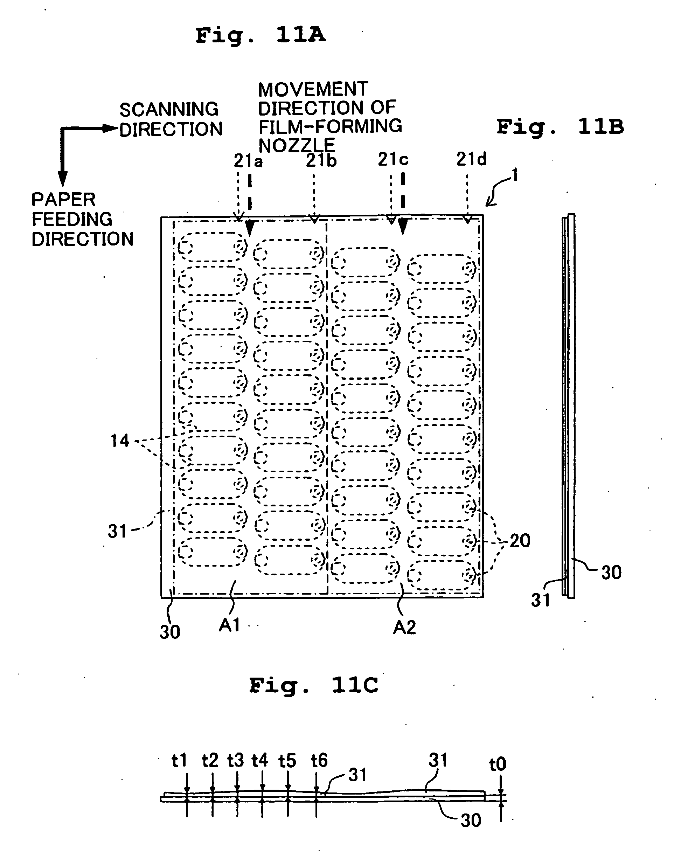

In view of the above situation, in this embodiment, as shown by broken-line arrows in Fig. 11A, a direction in which the film-forming nozzle 52 moves upon forming the piezoelectric material layer 31 is a direction parallel to the arrangement direction of the jetting nozzles 20 (pressure chambers 14) and is a direction perpendicular to the scanning direction of the ink-jet head 1 (a direction in which the recording paper 7 moves relative to the ink-jet head 1 upon performing the recording (upon performing scanning by the carriage)). More concretely, the film-forming nozzle 52 is moved, in the arrangement direction of the pressure chambers 14, relative to each of two areas arranged in the scanning direction on the vibration plate 30, namely an area A1 corresponding to two pressure chamber rows on one side in the scanning direction (left side in Fig. 11A) and an area A2 corresponding to two pressure chamber rows on the other side (right side in Fig. 11A) in the scanning direction, thereby forming the piezoelectric material layers 31 on the two areas A1, A2 respectively. A boundary between the piezoelectric material layers 31 formed on the two areas A1, A2 respectively is positioned between the second and third pressure chamber rows from the left in Fig. 11A, and the boundary does not overlap with any of the pressure chambers 14.

In this case, as shown in Fig. 11B, the piezoelectric material layers 31 are substantially uniform in thickness in the paper feeding direction which is the direction parallel to the movement direction of the film-forming nozzle 52. Therefore, ink droplets with substantially a same size are jetted from the jetting nozzles 20 forming the nozzle rows 21a to 21d.

On the other hand, , as shown in Fig. 11C, in the scanning direction of the ink-jet head 1 which is the direction perpendicular to the movement direction of the film-forming nozzle 52, the piezoelectric material layer 31 has a certain thickness distribution (t1 to t6). This thickness distribution is substantially same as the thickness distribution in Fig. 9B previously described. Here, if film-forming conditions such as a movement speed of the film-forming nozzle 52 (that is, a movement speed of the stage 53) and an amount of the aerosol jetted from the slit 55 are same when the piezoelectric material layers 31 are formed on the two areas A1, A2 of the vibration plate 30, then these two areas A1, A2 have substantially same thickness distribution.

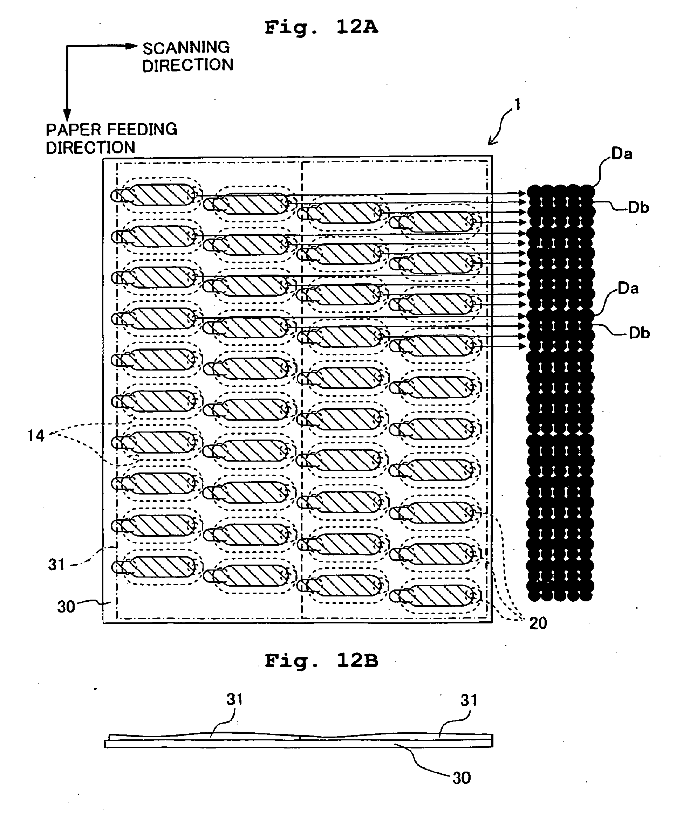

Therefore, the thickness of the piezoelectric material layer 31 in an area corresponding to the first pressure chamber row 21a from the left in Fig. 11A is different from the thickness of an area corresponding to the second pressure chamber row 21b, but is substantially equal to the thickness of an area corresponding to the third pressure chamber row 21c. Similarly, the thickness of the piezoelectric material layer 31 in the area corresponding to the second pressure chamber row 21b from the left is substantially equal to the thickness of an area corresponding to the fourth pressure chamber row 21d. Therefore, as shown in Fig. 12A, dots formed by the first nozzle row 21a are substantially equal in size to dots formed by the third nozzle row 21c, and dots formed by the second nozzle row 21b are also substantially equal in size to dots formed by the fourth nozzle row 21d. Further, since the jetting nozzles 20 belonging to each of the four nozzle rows 21a to 21d are arranged in sequence at a spacing distance of P/4 in the paper feeding direction as described above, dots Da, Db with two mutually different sizes are formed on the recording paper 7 alternately in the paper feeding direction by these four nozzle rows 21a to 21d.

A plurality of dots arranged in the paper feeding direction as shown in Fig. 12A change in size alternately by a very short span (spacing distance) of P/4. That is, as compared with Fig. 10, the dot size changes in a very short spacing distance, and such a change in the dot size is not easily recognized by eyes. Therefore, uneven shading (banding) in a recorded image and/or the like occurring due to the change in the dot size is not conspicuous. Accordingly, even if the piezoelectric material layer 31 has thickness distribution, deterioration in printing quality due to the thickness distribution is prevented.

As explained above, in this embodiment, the direction in which the film-forming nozzle 52 moves relative to the vibration plate 30 when the piezoelectric material layer 31 is formed is perpendicular to the scanning direction (the direction in which the recording paper 7 moves relative to the ink-jet head 1 at the time of recording) and is parallel to the arrangement direction of the jetting nozzles 20 (the direction of the nozzle rows 21a to 21d). Therefore, the influence that the thickness distribution occurring in the piezoelectric material layer 31 has on the variation in size of the dots formed in the paper feeding direction on the recording paper 7 is reduced, and accordingly, banding occurring due to the variation in size of the dots becomes less conspicuous. Namely, it is possible to prevent deterioration in printing quality due to the banding.

The ink-jet printer 100 of this embodiment is a color ink-j et printer including the four ink-j et heads 1 j jetting the four color inks respectively. The piezoelectric material layers 31 of these four ink-jet heads 1 are all formed by the same steps. Therefore, degrees of variation in size of dots formed on the recording paper 7 by the four ink-jet heads 1 are same among the heads, and there is no difference in size among dots of the respective colors, thereby suppressing the quality deterioration in the color printing.

Next, modifications in each of which the above-described embodiment is variously changed will be explained. Parts or components having same construction as those of the above-described embodiment will be assigned the same reference numerals, and explanation thereof will be omitted as appropriate.

### First modification

In the step for forming the piezoelectric material layer 31 of the above-described embodiment, the boundary between the piezoelectric material layers 31 formed on the two areas A1, A2 respectively, of the vibration plate 30 does not overlap with any of the pressure chambers 14 as shown in Fig. 11A. That is, the areas A1, A2 completely accommodate the active portions 31a, respectively, formed on the piezoelectric material layer 31, and the boundary between the piezoelectric material layers 31 does not cross any of the active portions 31a (see Fig. 8C). However, it is allowable that boundaries of the piezoelectric material layers 31 separately formed on a plurality of areas, respectively, of the vibration plate 30 overlap with the pressure chambers 14.

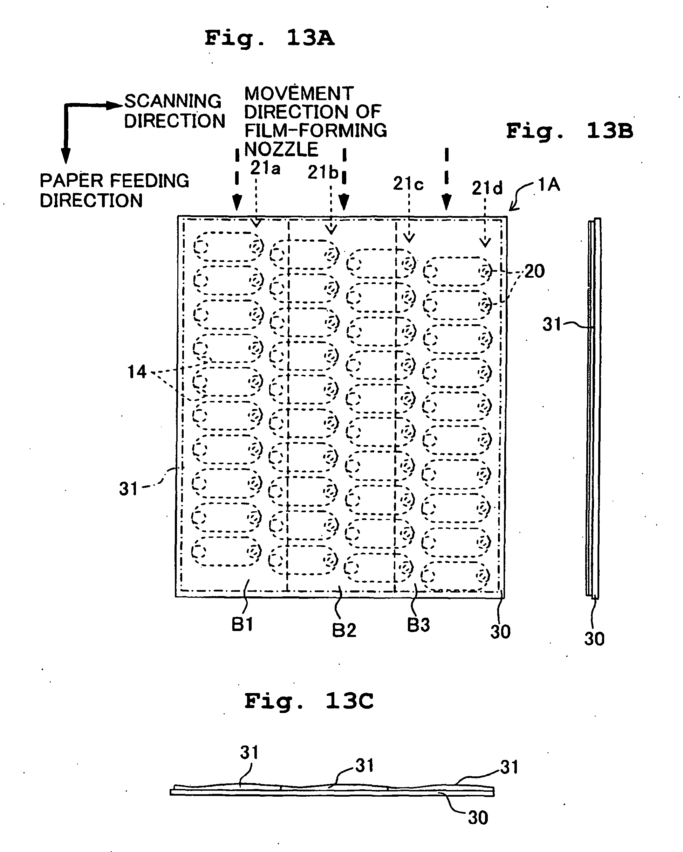

For example, as shown in Fig. 13A, the piezoelectric material layers 31 are formed on three areas B1, B2, B3 arranged on the upper surface of the vibration plate 30 in the scanning direction (right and left direction in Fig. 13A) by the film-forming nozzle 52 moving in the paper feeding direction (up and down direction in Fig. 13A) relative to the vibration plate 30 as shown by broken-line arrows. Here, the central area B2 partially overlaps with two central pressure chamber rows among four pressure chamber rows. That is, a boundary between a left area B1 and a central area B2 and a boundary between the center area B2 and a right area B3 overlap with the pressure chambers 14 (and the active portions). In an ink-jet head 1A thus produced also, the influence that the thickness distribution occurring in the piezoelectric material layers 31 has on variation in size of dots formed in the paper feeding direction on the recording paper 7 is reduced, thereby making banding hardly conspicuous.

To explain in more detail, as shown in Fig. 13B, the piezoelectric material layers 31 have substantially uniform thickness in the paper feeding direction. On the other hand, each of the piezoelectric material layers 31 formed on the three areas B1, B2, B3 respectively has a predetermined thickness distribution in the scanning direction. In the first modification, since the boundaries among the areas B1, B2, B3 overlap with the pressure chambers 14, the piezoelectric material layers 31 corresponding to the four pressure chamber rows are different in thickness, and thus ink droplets jetted from the four nozzle rows 21a to 21d respectively are different in volume. Consequently, dots with four different sizes are arranged in sequence in the paper feeding direction on the recording paper 7, resulting in a certain degree of variation in dot size. However, as compared with a case in which the film-forming nozzle 52 is moved in the scanning direction of the ink-jet head 1 to form the piezoelectric material layer 31 (see Fig. 10), a span (spacing distance) in which dot size is changed is sufficiently short, and accordingly, banding due to the variation in dot size becomes hardly conspicuous.

### Second modification

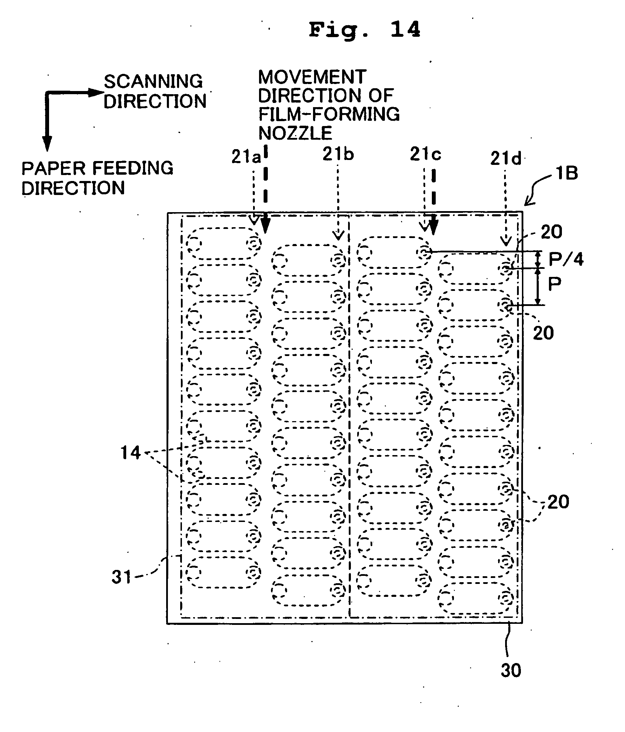

The arrangement of the jetting nozzles 20 is not limited to the form explained in the above-described embodiment. It is allowable that as shown in Fig. 14 for example, four nozzle rows 21a to 21d are arranged in such a manner that a first nozzle row 21a, a third nozzle row 21c, and a second nozzle row 21b, and a fourth nozzle rows 21d from the left are shifted in this order from one another toward the downstream in the paper feeding direction (downwardly in Fig. 14) by a spacing distance of P/4 (P is a spacing distance at which the jetting nozzles 20 are arranged in each of the nozzle rows 21a to 21d). Upon producing an ink-jet head 1B with such a construction, the film-forming nozzle 52 is relatively moved in the paper feeding direction (the arrangement direction of the jetting nozzles 20) to form the piezoelectric material layers 31. Consequently, each of the piezoelectric material layers 31 has thickness distribution in the scanning direction which is perpendicular to the arrangement direction of dots formed on the recording paper 7 at a spacing distance of P/4. Therefore, the influence that the thickness distribution has on variation in dot size is reduced, and thus banding due to a change in dot size is less conspicuous.

### Third modification

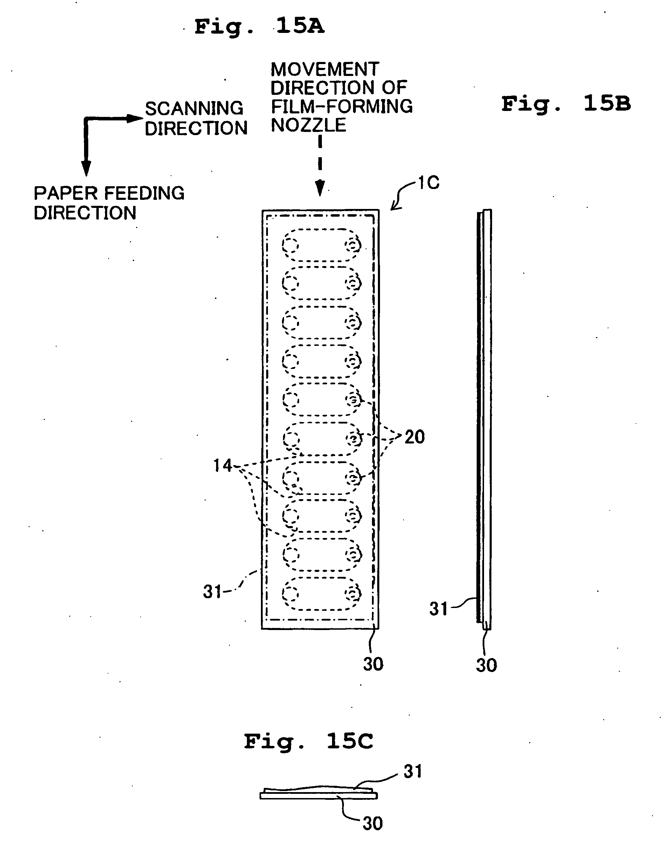

In this example, as shown in Fig. 15A, the jetting nozzles 20 arranged in the paper feeding direction and pressure chambers 14 corresponding to the nozzles 20 respectively are arranged in one row. Upon producing an ink-jet head 1C with such a construction, as shown by broken-line arrow in Fig. 15A, the film-forming nozzle 52 is moved relative to the vibration plate 30 in the paper feeding direction (the arrangement direction of the jetting nozzles 20 (pressure chambers 14)) to form the piezoelectric material layer 31. Consequently, as shown in Fig. 15B, the piezoelectric material layer 31 has a substantially uniform thickness in the arrangement direction of the jetting nozzles 20 aligned in one row, and therefore, there occurs no variation in volume of droplets jetted from these jetting nozzles 20. Namely, since dots formed by the one row of the jetting nozzles 20 are substantially equal in size, banding itself does not occur. Note that the piezoelectric material layer 31 has thickness distribution in the scanning direction as shown in Fig. 15C, but in a case in which the number of row of the jetting nozzles 20 is one, this thickness distribution does not influence the variation in volume of droplets (in size of dots) jetted from the jetting nozzles 20.

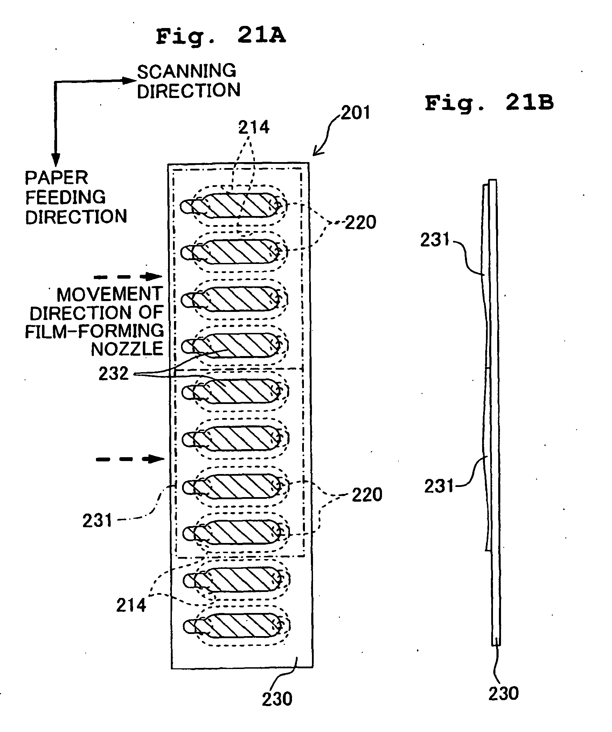

A comparative example of the third modification will be explained with reference to Figs. 21A and 21B. An ink-jet head 201 shown in Fig. 21A is a serial-type ink-jet head which jets ink onto a recording paper (not shown) while moving in a right and left direction (scanning direction) in Fig. 21A. The recording paper is fed (transported) in an up and down direction (paper feeding direction) in Fig. 21A perpendicular to the scanning direction. Further, in the ink-jet head 201, similarly to the case of Fig. 15A, it is assumed that a plurality of jetting nozzles 220 and a plurality of pressure chambers 214 communicating with the jetting nozzles 220 respectively are arranged in one row in the paper feeding direction. Further, a vibration plate 230 (substrate) is arranged to cover the pressure chambers 214, and piezoelectric material layers 231 are arranged on the upper surface of the vibration plate 230. Further, on the upper surface of each of the piezoelectric material layers 231, a plurality of electrodes 232 which generate an electric field in the piezoelectric material layer 231 are provided on areas corresponding to the pressure chambers 214 respectively.

In the ink-jet head 201 shown in Figs. 21A, 21B, if a direction of the relative movement of a film-forming nozzle (direction indicated by broken-line arrows), when the piezoelectric material layers 231 to be arranged to cover the pressure chambers 213 are formed, is parallel to the scanning direction, then each of the piezoelectric material layers 231 has thickness distribution in a direction parallel to the arrangement direction of the jetting nozzles 220 (pressure chambers 214) as shown in Fig. 21B, and due to the thickness distribution, pressures applied to the inks in the pressure chambers 214 respectively vary greatly among the pressure chambers 214. That is, the thickness distribution of the piezoelectric material layer 231 directly appears as variation in size among a plurality of dots arranged in the paper feeding direction (up and down direction in Fig. 21A), and when a large number of such dot rows are arranged in the scanning direction, there occurs nonuniform shading (banding) recognizable at a glance.

### Fourth modification

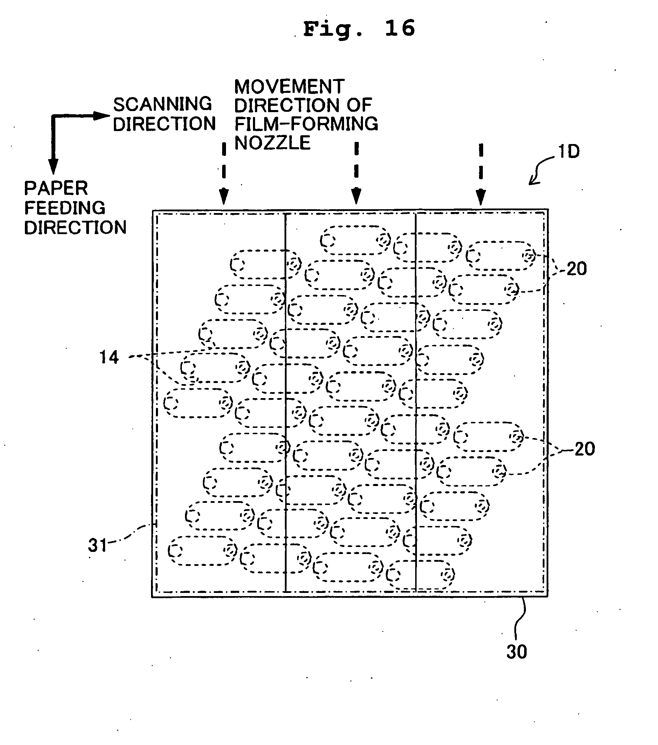

In this example, as shown in Fig. 16, rows of the jetting nozzles 20 (pressure chambers 14) are arranged to be inclined with respect to (to intersect with) the scanning direction at a predetermined angle. In such an ink-jet head 1D, the jetting nozzles arranged in a direction inclined with respect to the scanning direction form dots arranged at an equal spacing distance in the paper feeding direction. Upon producing this ink-jet head 1D, as shown by broken-line arrows in Fig. 16, the film-forming nozzle 52 is moved relative to the vibration plate 30 in the paper feeding direction to form the piezoelectric material layers 31. Consequently, since each of the piezoelectric material layers 31 has thickness distribution in the scanning direction perpendicular to the arrangement direction of the dots formed on the recording paper 7, the influence that the thickness distribution has on variation in size of the dots is reduced.

### Fifth modification

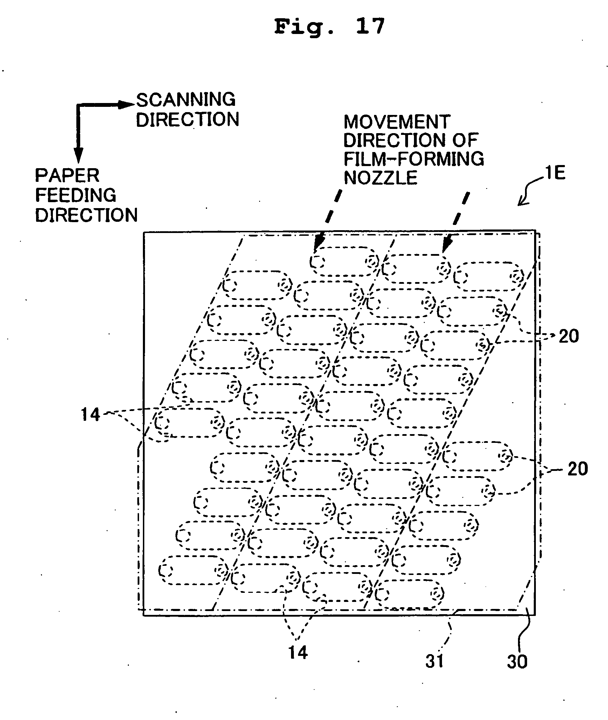

As shown in Fig. 17, in this example, upon producing an ink-jet head 1E having a construction in which rows of the jetting nozzles 20 (pressure chambers 14) are inclined with respect to the scanning direction at a predetermined angle, the film-forming nozzle 52 is moved relative to the vibration plate 30 in the arrangement direction of the jetting nozzles 20 (pressure chambers 14) (that is, a direction intersecting with the scanning direction which is the movement direction of the recording paper 7 relative to the ink-jet head 1E at the time of recording) . In this case, each of the piezoelectric material layers 31 has thickness distribution in the direction perpendicular to the arrangement direction of the jetting nozzles 20 (pressure chambers 14), but the direction in which the thickness distribution occurs is a direction different from the arrangement direction of dots formed on the recording paper 7 (paper feeding direction). Therefore, the influence that the thickness distribution of the piezoelectric material layer 31 has on variation in size of the dots is reduced.

### Sixth modification

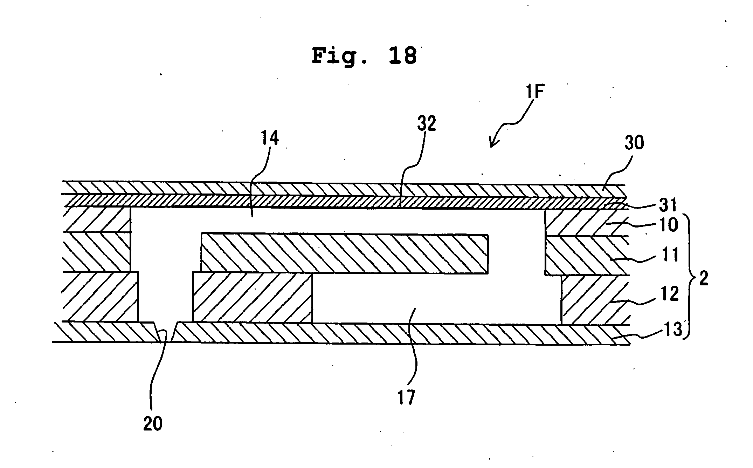

It is not necessarily indispensable that the piezoelectric material layer 31 is formed on a surface of the vibration plate on a side opposite to the channel unit. It is allowable that the piezoelectric material layer 31 is formed on a surface of the vibration plate 30 on a side of the channel unit 2 as in an ink-jet head 1F shown in Fig. 18.

### Seventh modification

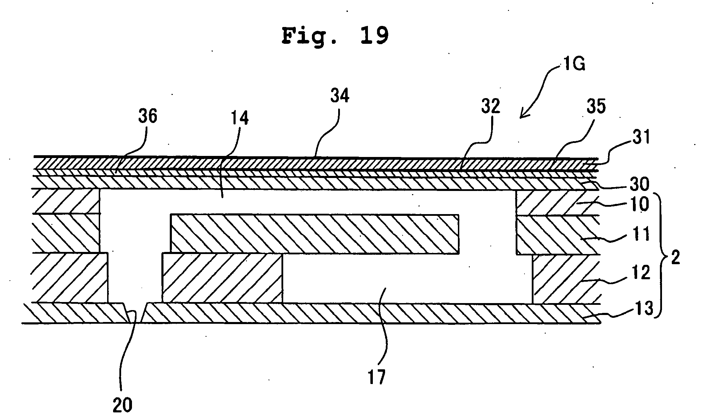

In the above-described embodiment, the piezoelectric material layer 31 which is one of the thin film layers forming the piezoelectric actuator 3 is formed by the AD method, but a thin film layer other than the piezoelectric material layer 31 may be formed by the AD method. For example, a construction of an ink-jet head 1G shown in Fig. 19 is also adoptable, in which individual electrodes 32 are arranged on the upper surface of the vibration plate 30 (lower surface of the piezoelectric material layer 31) and a common electrode 34 is arranged on the upper surface of the piezoelectric material layer 31 to commonly face the individual electrodes. This construction is advantageous in that a wiring for supplying a driving voltage to the individual electrodes 32 is easily arranged and drawn on the upper surface of the vibration plate 30. However, in a case in which the vibration plate 30 is a metal plate, an insulation layer 36 insulating the vibration plate 30 and the individual electrodes 32 from each other needs to be provided. This insulation layer 36 needs to have a certain degree of rigidity, similarly to the vibration plate 30, in order to surely transmit the deformation of the piezoelectric material layer 31 to the inks in the pressure chambers, and the insulation layer 36 is formed of an insulative ceramic material such as alumina, zirconia or the like.

The insulation layer 36 made of the ceramic material such as alumina can be formed by the AD method as in the step for forming the piezoelectric material layer 31 previously described. Namely, while the film-forming nozzle 52 having the slit 55 is moved relative to the vibration plate 30 in a predetermined direction, aerosol which contains fine particles of the ceramic material forming the insulation layer 36 and a carrier gas is sprayed to the vibration plate 30 from the slit 55 of the film-forming nozzle 52 (see Figs. 8A and 8B). At this time, as in the case of forming the piezoelectric material layer 31, thickness distribution easily occurs also in the insulation layer 36 in a direction perpendicular to the movement direction of the film-forming nozzle 52. The thickness distribution results in nonuniform rigidity of the insulation layer 36 and thus influences droplet jetting characteristics.

Therefore, the film-forming nozzle 52 is moved relative to the vibration plate 30 in the paper feeding direction (or, in the direction inclined with respect to the paper feeding direction at a predetermined angle as in the fifth modification (see Fig. 17) described above). Consequently, a direction in which thick portions are formed in the insulation layer 36 is different from the arrangement direction of dots on the recording paper 7 and thus the influence of the thickness distribution on variation in size of the dots is reduced, thereby making banding occurring due to the nonuniform size of the dots to be hardly conspicuous.

In the seventh modification, both of the insulation layer 36 and the piezoelectric material layer 31 may be formed by the above-described film-forming step using the AD method, or the piezoelectric material layer 31 may be formed by a method other than the AD method.

### Eighth modification

The embodiment and its modifications described above are examples in which the present invention is applied to the producing method for the serial-type ink-jet head, but the present invention is also applicable to a line-type ink-jet head.

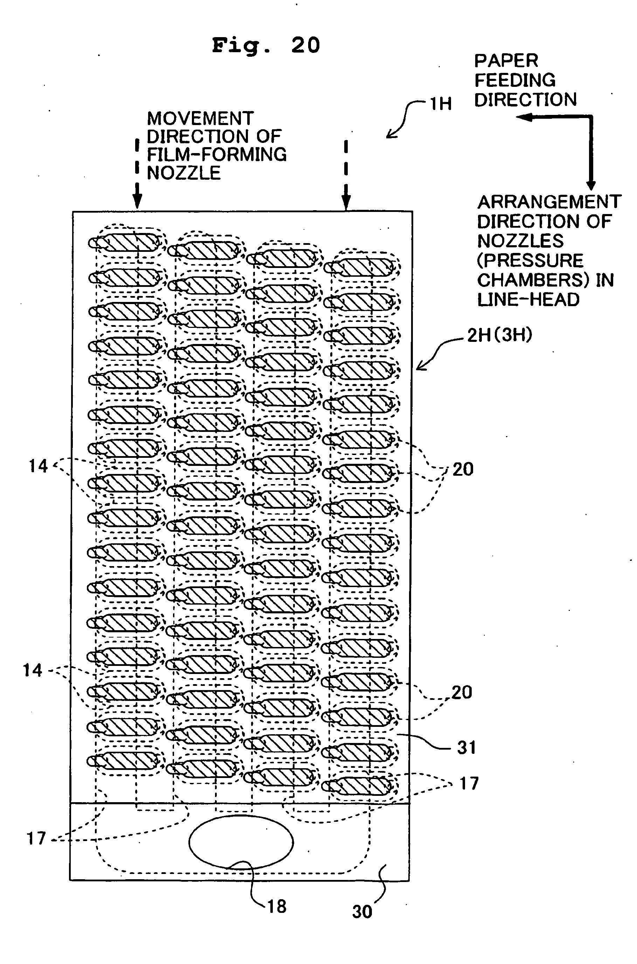

As shown in Fig. 20, a line-type ink-jet head 1H according to the eighth modification is fixedly provided on a frame (not shown) of a printer. In the line-type ink-jet head 1H, the head is not moved by the carriage unlike the serial-type ink-jet head. Therefore, in the case of the line-type ink-jet head, the relative-movement direction in which the recording paper is moved relative to the ink-jet head at the time of recording is the paper feeding direction in which a paper is fed by transporting rollers (moving unit: see Fig. 1) or the like (in the serial-type ink-jet head, the relative-movement direction of the recording paper relative to the ink-jet head is the scanning direction). This ink-jet head 1H includes a channel unit 2H in which an ink channel is formed and a piezoelectric actuator 3H arranged on the upper surface of the channel unit 2H.

The channel unit 2H has a plurality of jetting nozzles 20 arranged in four rows and at an equal spacing distance in a longitudinal direction of the head (up and down direction in Fig. 20) which is perpendicular to a paper feeding direction (right and left direction in Fig. 20) in which the recording paper 7 is fed; and a plurality of pressure chambers 14 arranged in four rows corresponding to the jetting nozzles 20 respectively. Inks are supplied to the pressure chambers 14 from an ink supply port 18 via manifolds 17. The construction of the individual ink channels from the manifolds to the jetting nozzles 20 via the pressure chambers 14 is substantially the same as that of the above-described embodiment, and therefore, detailed explanation thereof will be omitted.

The piezoelectric actuator 3H includes a vibration plate 30 covering the pressure chambers 14; a piezoelectric material layer 31 arranged on the upper surface of the vibration plate 30; and a plurality of individual electrodes 32 arranged on the upper surface of the piezoelectric material layer 31 corresponding to the pressure chambers 14 respectively. The piezoelectric actuator 3H has a similar construction as that of the above-described embodiment, and therefore, detailed explanation thereof will be omitted.

The line-type ink-jet head 1H jets the inks from the jetting nozzles 20 to a recording paper 7 fed in the right and left direction in Fig. 20 to form, on the recording paper 7, dots arranged in parallel to the arrangement direction of the jetting nozzles 20. In producing steps of the line-type ink-jet head 1H, upon forming the piezoelectric material layer 31 of the piezoelectric actuator 3H on the upper surface of the vibration plate 30, aerosol is jetted from the film-forming nozzle 52 to the vibration plate 30 while the film-forming nozzle 52 is moved relative onto the vibration plate 30 in a direction parallel to the arrangement direction of the jetting nozzles 20 (direction perpendicular to the paper feeding direction) as shown by broken-line arrows in Fig. 20. At this time, the piezoelectric material layer 31 formed on the vibration plate 30 has thickness distribution in the paper feeding direction which is the direction perpendicular to the movement direction of the film-forming nozzle 52.

However, since a direction in which the thickness distribution occurs is perpendicular to the arrangement direction of dots formed on the recording paper 7 (the arrangement direction of the jetting nozzles 20), the influence that the thickness distribution of the piezoelectric material layer 31 has on variation in size of the dots is small and thus banding due to the variation is not conspicuous.

Although the present invention has been specifically explained based on the above-described embodiment and its modifications, the present invention is not limited to these and encompasses any improvement and modification thereof reached by a person skilled in the art falling under the scope of the claims. The construction, dimension, and material of the ink-jet head are not limited to those described in the above-described forms but those of various kinds are usable. The case in which the piezoelectric actuator is applied to the ink-jet head is explained, but the present invention is not limited to this, and is applicable to various kinds of liquid jetting or transport apparatuses.

## Claims

1. A method for producing a piezoelectric actuator (3) which has a substrate (30) and a plurality of thin film layers disposed on the substrate and including a piezoelectric material layer (31), and in which a plurality of elongated active potions (31a) are defined in the piezoelectric material layer (31), the method comprising:
a step for forming the piezoelectric material layer (31) on the substrate; and
a step for forming another thin film layer (32) other than the piezoelectric material layer (31) on the substrate;
wherein at least one thin film layer among the thin film layers is formed by jetting aerosol, which contains particles forming the thin film, layer and a carrier gas, from a slit (55) formed in a film-forming nozzle (52) while moving the film-forming nozzle (52) having the slit relative to the substrate in a direction which is a smaller width direction of the slit (55) and is a direction intersecting with a length direction of the elongated active portions.

2. The method for producing the piezoelectric actuator according to claim 1, wherein the at least one thin film layer is the piezoelectric material layer.

3. The method for producing the piezoelectric actuator according to claim 1, wherein the thin film layers include a metal plate and an insulation layer; and the at least one thin film layer is the insulation layer.

4. The method for producing the piezoelectric actuator according to claim 1, wherein the active portions are portions, of the piezoelectric material layer, sandwiched between electrodes.

5. A method for producing an ink-jet head including a channel unit having a plurality of elongated pressure chambers which are arranged along a plane, and a plurality of jetting nozzles which communicate with the pressure chambers respectively and which jet an ink onto a recording medium; and including producing the piezoelectric actuator by the method as defined in claim 1, the method comprising:
a step for providing the piezoelectric actuator; and
a step for attaching the channel unit to the substrate of the piezoelectric layer,
wherein the length direction of the elongated active portions of the piezoelectric actuator is a length direction of the elongated pressure chambers.

6. The method for producing the ink-jet head according to claim 5, wherein the direction intersecting with the length direction of the elongated pressure chambers is a direction perpendicular to the length direction of the elongated pressure chambers.

7. The method for producing the ink-jet head according to claim 5, wherein the slit of the film-forming nozzle has a slit-length to an extent that a jetting area formed by the aerosol jetted from the slit to the substrate covers at least one of the pressure chambers.

8. The method for producing the ink-jet head according to claim 5, wherein the direction intersecting with the length direction of the elongated pressure chambers is a direction perpendicular to a relative-movement direction in which the recording medium is moved relative to the ink-jet head upon performing recording using the ink-jet head.

9. The method for producing the ink-jet head according to claim 5, wherein:
the jetting nozzles are arranged to form, on the recording medium, a plurality of dots arranged in an arrangement direction at an equal spacing distance; and
a relative-movement direction in which the film-forming nozzle is moved relative to the substrate is the arrangement direction in which the dots are arranged.

10. The method for producing the ink-jet head according to claim 5, wherein:
the jetting nozzles are arranged at least in an arrangement direction; and
a relative-movement direction in which the film-forming nozzle is moved relative to the substrate is the arrangement direction in which the jetting nozzles are arranged.

11. The method for producing the ink-jet head according to claim 10, wherein:
the jetting nozzles are arranged in a matrix form in a first arrangement direction and a second arrangement direction intersecting with the first arrangement direction; and
the relative-movement direction in which the film-forming nozzle is moved relative to the substrate is an arrangement direction same as one of the first arrangement direction and the second arrangement direction, in which jetting nozzles among the jetting nozzles are arranged in a number greater than that of jetting nozzles arranged in the other of the first and second arrangements directions.

12. The method for producing the ink-jet head according to claim 5, wherein in the aerosol jetting, the aerosol is jetted to a plurality of jetting areas, of the substrate, arranged in a relative-movement direction in which the recording mediums is moved relative to the ink-jet head while the film-forming nozzle is moved relative to each of the jetting areas.

13. The method for producing the ink-jet head according to claim 5, wherein the piezoelectric material layer is formed on the substrate on the other surface thereof on a side opposite to the channel unit.

14. The method for producing the ink-jet head according to claim 5, wherein:
the ink-jet head is a serial-type ink-jet head which jets the ink from the jetting nozzles onto the recording medium transported in a transporting direction perpendicular to a predetermined scanning direction while moving in the scanning direction; and
a relative-movement direction in which the film-forming nozzle is moved relative to the substrate is the transporting direction in which the recording medium is transported.

15. The method for producing the ink-jet head according to claim 5, wherein:
the ink-jet head is a line-type ink-jet head having the jetting nozzles arranged at an equal spacing distance in an arrangement direction perpendicular to a transporting direction in which the recording medium is transported; and
a relative-movement direction in which the film-forming nozzle is moved relative to the substrate is the arrangement direction of the jetting nozzles.

16. A method for producing an ink-jet printer including producing the ink-jet head by the method as defined in claim 5; and a moving unit which moves the ink-jet head relative to the recording medium in a relative-movement direction; the method comprising:
a step for providing the ink-jet head; and
a step for providing the movement unit;
wherein the smaller width direction of the slit and is a direction intersecting with the relative-movement direction.

17. The method for producing the ink-jet printer according to claim 16, wherein the ink-jet head includes a plurality of heads which jet a plurality different color inks respectively.

18. An ink-jet head (1) which jets an ink, comprising:
a channel unit (2) having a plurality of elongated pressure chambers (14) which are arranged along a plane, and a plurality of jetting nozzles (20) which communicate with the pressure chambers (14) respectively and which jet the ink; and
a piezoelectric actuator (3) having a flat substrate (30) disposed on one surface of the channel unit to cover the pressure chambers, and a plurality of thin film layers disposed on one surface of the substrate, the thin film layers including a piezoelectric material layer (31);
wherein in at least one thin film layer among the thin film layers, thickness uniformity of the thin film layer in a direction intersecting with the length direction of the elongated pressure chambers is higher than thickness uniformity of the thin film layer in a direction perpendicular to the intersecting direction.

19. The ink-jet head according to claim 18, wherein the at least one thin film layer is formed by jetting aerosol, which contains particles forming the thin film layer and carrier gas, from a slit formed in a film-forming nozzle while moving the film-forming nozzle having the slit relative to the substrate in a direction which is a smaller width direction of the slit and is the direction intersecting with the predetermined direction.

20. The ink-jet head according to claim 18,
wherein a plurality of elongated active portions are defined in the piezoelectric material layer; and
in at least one thin film layer among the thin film layers, thickness uniformity of the thin film layer in a direction intersecting with a length of the elongated active portions is higher than thickness uniformity of the thin film layer in a direction perpendicular to the intersecting direction.

21. The ink-jet head according to claim 20, wherein the at least one thin film layer is formed by jetting aerosol, which contains particles forming the thin film layer and a carrier gas, from a slit formed in a film-forming nozzle while moving the film-forming nozzle having the slit relative to the substrate in a direction which is a smaller width direction of the slit and is the intersecting direction.

22. The ink-jet head according to claim 21, wherein the intersecting direction is a direction perpendicular to the length direction of the elongated active portions.

23. An ink-jet printer having the ink-jet head as defined in claim 18, comprising:
a moving unit which moves the ink-jet head relative to the recording medium in a relative-movement direction,
wherein in at least one thin film layer among the thin film layers, thickness uniformity of the thin film layer in a direction intersecting with the relative-movement direction is higher than thickness uniformity of the thin film layer in a direction perpendicular to the intersecting direction.

24. The ink-jet printer according to claim 23, wherein the at least one thin film layer is formed by jetting aerosol, which contains particles forming the thin film layer and a carrier gas, from a slit formed in a film-forming nozzle while moving the film-forming nozzle having the slit relative to the substrate in a direction which is a smaller width direction of the slit and is the intersecting.

## Patentansprüche

1. Verfahren zum Herstellen eines Piezoaktors (3), der ein Substrat (30) und eine Mehrzahl von auf dem Substrat angeordneten Dünnfilmschichten aufweist und eine piezoelektrische Materialschicht (31) beinhaltet, und in dem eine Mehrzahl von länglichen aktiven Abschnitten (31a) in der piezoelektrischen Materialschicht (31) definiert ist, wobei das Verfahren folgende Schritte beinhaltet:
einen Schritt zum Ausbilden der piezoelektrischen Materialschicht (31) auf dem Substrat; und
einen Schritt zum Ausbilden einer anderen Dünnfilmschicht (32) als der piezoelektrischen Materialschicht (31) auf dem Substrat;
wobei zumindest eine Dünnfilmschicht von den Dünnfilmschichten gebildet wird, indem Aerosol, das Partikel, aus denen die Dünnfilmschicht besteht, und ein Trägergas enthält, aus einem Schlitz (55), der in einer Filmerzeugungsdüse (52) ausgebildet ist, ausgestoßen wird, während die Filmerzeugungsdüse (52) mit dem Schlitz relativ zu dem Substrat in einer Richtung bewegt wird, die eine Breitenrichtung des Schlitzes (55) ist, und die eine Richtung ist, die eine Längsrichtung der länglichen aktiven Abschnitte schneidet.

2. Verfahren zum Herstellen des Piezoaktors nach Anspruch 1, wobei die zumindest eine Dünnfilmschicht die piezoelektrische Materialschicht ist.

3. Verfahren zum Herstellen des Piezoaktors nach Anspruch 1, wobei die Dünnfilmschichten eine Metallplatte und eine Isolierschicht beinhalten; und die zumindest eine Dünnfilmschicht die Isolierschicht ist.

4. Verfahren zum Herstellen des Piezoaktors nach Anspruch 1, wobei es sich bei den aktiven Abschnitten um Abschnitte der piezoelektrischen Materialschicht handelt, die zwischen Elektroden angeordnet sind.

5. Verfahren zum Herstellen eines Tintenstrahlkopfs, der eine Kanaleinheit mit einer Mehrzahl von länglichen Druckkammern, die entlang einer Ebene angeordnet sind, und eine Mehrzahl von Ausstoßdüsen aufweist, die jeweils mit den Druckkammern kommunizieren und die eine Tinte auf ein Aufzeichnungsmedium ausstoßen; und wobei das Verfahren ein Herstellen des Piezoaktors durch das nach Anspruch 1 definierte Verfahren beinhaltet, wobei das Verfahren folgende Schritte beinhaltet:
einen Schritt zum Bereitstellen des Piezoaktors; und
einen Schritt zum Anbringen der Kanaleinheit an das Substrat der piezoelektrischen Schicht;
wobei die Längsrichtung der länglichen aktiven Abschnitte des Piezoaktors eine Längsrichtung der länglichen Druckkammern ist.

6. Verfahren zum Herstellen des Tintenstrahlkopfs nach Anspruch 5, wobei die Richtung, die die Längsrichtung der länglichen Druckkammern schneidet, eine Richtung ist, die senkrecht zur Längsrichtung der länglichen Druckkammern verläuft.

7. Verfahren zum Herstellen des Tintenstrahlkopfs nach Anspruch 5, wobei der Schlitz der Filmerzeugungsdüse eine derart große Schlitzlänge aufweist, dass eine Ausstoßfläche, die durch das aus dem Schlitz auf das Substrat ausgestoßene Aerosol gebildet wird, zumindest eine der Druckkammern bedeckt.

8. Verfahren zum Herstellen des Tintenstrahlkopfs nach Anspruch 5, wobei die Richtung, die die Längsrichtung der länglichen Druckkammern schneidet, eine Richtung ist, die senkrecht zu einer relativen Bewegungsrichtung verläuft, in der das Aufzeichnungsmedium relativ zu dem Tintenstrahlkopf bewegt wird, nachdem unter Verwendung des Tintenstrahlkopf ein Aufzeichnungsvorgang ausgeführt worden ist.

9. Verfahren zum Herstellen des Tintenstrahlkopfs nach Anspruch 5, wobei:
die Ausstoßdüsen so angeordnet sind, dass sie, auf dem Aufzeichnungsmedium, eine Mehrzahl von Punkten ausbilden, die in einer Anordnungsrichtung gleichmäßig voneinander beabstandet angeordnet sind; und
eine relative Bewegungsrichtung, in der die Filmerzeugungsdüse relativ zu dem Substrate bewegt wird, die Anordnungsrichtung ist, in der die Punkte angeordnet sind.

10. Verfahren zum Herstellen des Tintenstrahlkopfs nach Anspruch 5, wobei:
die Ausstoßdüsen zumindest in einer Anordnungsrichtung angeordnet sind; und
eine relative Bewegungsrichtung, in der die Filmerzeugungsdüse relativ zu dem Substrat bewegt wird, die Anordnungsrichtung ist, in der die Ausstoßdüsen angeordnet sind.

11. Verfahren zum Herstellen des Tintenstrahlkopfs nach Anspruch 10, wobei:
die Ausstoßdüsen in einer Matrixform in einer ersten Anordnungsrichtung und einer zweiten Anordnungsrichtung angeordnet sind, die die erste Anordnungsrichtung schneidet; und
die relative Bewegungsrichtung, in der die Filmerzeugungsdüse relativ zu dem Substrat bewegt wird, eine Anordnungsrichtung ist, die mit der ersten Anordnungsrichtung und der zweiten Anordnungsrichtung identisch ist, in der Ausstoßdüsen von den Ausstoßdüsen in einer Anzahl angeordnet sind, die größer ist als die von Ausstoßdüsen, die in der anderen von der ersten und zweiten Anordnungsrichtung angeordnet sind.

12. Verfahren zum Herstellen des Tintenstrahlkopfs nach Anspruch 5, wobei, während des Aerosolausstoßvorgangs, das Aerosol auf eine Mehrzahl von Ausstoßflächen des Substrats, ausgestoßen wird, die in einer relativen Bewegungsrichtung angeordnet sind, in der das Aufzeichnungsmedium relativ zu dem Tintenstrahlkopf bewegt wird, während die Filmerzeugungsdüse relativ zu jeder der Ausstoßflächen bewegt wird.

13. Verfahren zum Herstellen des Tintenstrahlkopfs nach Anspruch 5, wobei die piezoelektrische Materialschicht auf dem Substrat auf der anderen Oberfläche desselben auf einer der Kanaleinheit gegenüberliegenden Seite ausgebildet wird.

14. Verfahren zum Herstellen des Tintenstrahlkopfs nach Anspruch 5, wobei:
der Tintenstrahlkopf ein serieller Tintenstrahlkopf ist, der die Tinte aus den Ausstoßdüsen auf das Aufzeichnungsmedium ausstößt, das in einer Transportrichtung senkrecht zur einer vorbestimmten Abtastrichtung transportiert wird, während es sich in der Abtastrichtung bewegt; und
eine relative Bewegungsrichtung, in der die Filmerzeugungsdüse relativ zu dem Substrat bewegt wird, die Transportrichtung ist, in der das Aufzeichnungsmedium transportiert wird.

15. Verfahren zum Herstellen des Tintenstrahlkopfs nach Anspruch 5, wobei:
der Tintenstrahlkopf ein Zeilen-Tintenstrahlkopf ist, bei dem die Ausstoßdüsen gleichmäßig voneinander beabstandet in einer Anordnungsrichtung senkrecht zu einer Transportrichtung angeordnet sind, in der das Aufzeichnungsmedium transportiert wird; und
eine relative Bewegungsrichtung, in der die Filmerzeugungsdüse relativ zu dem Substrat bewegt wird, die Anordnungsrichtung der Ausstoßdüsen ist.

16. Verfahren zum Herstellen eines Tintenstrahldruckers, das den Schritt des Herstellens des Tintenstrahlkopfs durch das nach Anspruch 5 definierte Verfahren beinhaltet, und eine Bewegungseinheit, die den Tintenstrahlkopf relativ zu dem Aufzeichnungsmedium in einer relativen Bewegungsrichtung bewegt; wobei das Verfahren folgende Schritte beinhaltet:
einen Schritt zum Bereitstellen des Tintenstrahlkopfs; und
einen Schritt zum Bereitstellen der Bewegungseinheit;
wobei die Breitenrichtung des Schlitzes eine Richtung ist, die die relative Bewegungsrichtung schneidet.

17. Verfahren zum Herstellen des Tintenstrahldruckers nach Anspruch 16, wobei der Tintenstrahlkopf eine Mehrzahl von Köpfen beinhaltet, die jeweils ein Mehrzahl von unterschiedlichen Farbtinten ausstoßen.

18. Tintenstrahlkopf (1), der eine Tinte ausstößt, aufweisend:
eine Kanaleinheit (2) mit einer Mehrzahl von länglichen Druckkammern (14), die entlang einer Ebene angeordnet sind, und einer Mehrzahl von Ausstoßdüsen (20), die mit den Druckkammern (14) jeweils kommunizieren und die die Tinte ausstoßen; und
einen Piezoaktor (3) mit einem flachen Substrat (30), das auf einer Oberfläche der Kanaleinheit angeordnet ist, um die Druckkammern zu bedecken, und einer Mehrzahl von Dünnfilmschichten, die auf einer Oberfläche des Substrats angeordnet ist, wobei die Dünnfilmschichten eine piezoelektrische Materialschicht (31) beinhalten;
wobei, in zumindest einer Dünnfilmschicht von den Dünnfilmschichten, die Homogenität der Dicke der Dünnfilmschicht in einer Richtung, die die Längsrichtung der länglichen Druckkammern schneidet, höher ist als die Homogenität der Dicke der Dünnfilmschicht in einer Richtung senkrecht zu der Schnittrichtung.

19. Tintenstrahlkopf nach Anspruch 18, wobei die zumindest eine Dünnfilmschicht durch Ausstoßen von Aerosol, das Partikel, aus denen die Dünnfilmschicht besteht, und ein Trägergas enthält, aus einem Schlitz (55), der in der Filmerzeugungsdüse ausgebildet ist, gebildet wird, während die Filmerzeugungsdüse mit dem Schlitz relativ zu dem Substrat in einer Richtung bewegt wird, die eine Breitenrichtung des Schlitzes ist, und die Richtung ist, die die vorbestimmte Richtung schneidet.

20. Tintenstrahlkopf nach Anspruch 18,
wobei eine Mehrzahl von länglichen aktiven Abschnitten in der piezoelektrischen Materialschicht definiert sind; und
in zumindest einer Dünnfilmschicht von den Dünnfilmschichten, die Homogenität der Dicke der Dünnfilmschicht in einer Richtung, die eine Länge der länglichen aktiven Abschnitte schneidet, höher ist als die Homogenität der Dicke der Dünnfilmschicht in einer Richtung senkrecht zu der Schnittrichtung.

21. Tintenstrahlkopf nach Anspruch 18, wobei die zumindest eine Dünnfilmschicht durch Ausstoßen von Aerosol, das Partikel, aus denen die Dünnfilmschicht besteht, und ein Trägergas enthält, aus einem Schlitz (55), der in der Filmerzeugungsdüse ausgebildet ist, gebildet wird, während die Filmerzeugungsdüse (55) mit dem Schlitz relativ zu dem Substrat in einer Richtung bewegt wird, die eine Breitenrichtung des Schlitzes ist, und die die Schnittrichtung ist.

22. Tintenstrahlkopf nach Anspruch 21, wobei die Schnittrichtung eine Richtung senkrecht zu der Längsrichtung der länglichen aktiven Abschnitte ist.

23. Tintenstrahldrucker mit dem Tintenstrahlkopf nach Anspruch 18, aufweisend:
eine Bewegungseinheit, die den Tintenstrahlkopf relativ zu dem Aufzeichnungsmedium in einer relativen Bewegungsrichtung bewegt,
wobei in zumindest einer Dünnfilmschicht von den Dünnfilmschichten, die Homogenität der Dicke der Dünnfilmschicht in einer Richtung, die die relative Bewegungsrichtung schneidet, höher ist als die Homogenität der Dicke der Dünnfilmschicht in einer Richtung senkrecht zu der Schnittrichtung.

24. Tintenstrahldrucker nach Anspruch 23, wobei die zumindest eine Dünnfilmschicht durch Ausstoßen von Aerosol, das Partikel, aus denen die Dünnfilmschicht besteht, und ein Trägergas enthält, aus einem Schlitz (55), der in einer Filmerzeugungsdüse ausgebildet ist, gebildet wird, während die Filmerzeugungsdüse mit dem Schlitz relativ zu dem Substrat in einer Richtung bewegt wird, die eine Breitenrichtung des Schlitzes ist, und die die Schnittrichtung ist.

## Revendications

1. Procédé de fabrication d'un actuateur piézoélectrique (3) comprenant un substrat (30) et une pluralité de couches minces de film disposée sur le substrat et comprenant une couche de matériau piézoélectrique (31), et dans lequel une pluralité de sections actives allongées (31a) est définie dans la couche de matériau piézoélectrique (31), le procédé comprenant :
une étape consistant à former la couche de matériau piézoélectrique (31) sur le substrat ; et
une étape consistant à former une autre couche mince de film (32) différente de la couche de matériau piézoélectrique (31) sur le substrat ;
dans lequel au moins un couche mince de film parmi les couches minces de film est formée en projetant un aérosol qui contient des particules de formation de la couche mince de film et un gaz porteur à travers une fente (55) formée dans une buse de formation de film (52) tout en déplaçant la buse de formation de film (52) qui comporte la fente par rapport au substrat dans une direction qui est une direction plus courte dans le sens de la largeur de la fente (55) et qui est une direction qui coupe une direction dans le sens de la longueur des sections actives allongées.

2. Procédé de fabrication de l'actuateur piézoélectrique selon la revendication 1, dans lequel la au moins une couche mince de film est la couche de matériau piézoélectrique.

3. Procédé de fabrication de l'actuateur piézoélectrique selon la revendication 1, dans lequel les couches minces de film comprennent une plaque métallique et une couche isolante ; et la au moins un couche mince de film est la couche isolante.

4. Procédé de fabrication de l'actuateur piézoélectrique selon la revendication 1, dans lequel les sections actives sont des sections de la couche de matériau piézoélectrique, prises en sandwich entre des électrodes.

5. Procédé de fabrication d'une tête d'impression à jet d'encre comprenant une unité de canal comprenant une pluralité de chambres de pression allongées qui sont agencées le long d'un plan, et une pluralité de buses de projection qui communiquent avec les chambres de pression respectivement et qui projette une encre sur un support d'enregistrement ; et comprenant la fabrication de l'actuateur piézoélectrique par le procédé selon la revendication 1, le procédé comprenant :
une étape consistant à réaliser l'actuateur piézoélectrique ; et
une étape consistant à fixer l'unité de canal au substrat de la couche piézoélectrique,
dans lequel la direction dans le sens de la longueur des sections actives allongées de l'actuateur piézoélectrique est une direction dans le sens de la longueur des chambres de pression allongées.

6. Procédé de fabrication de la tête d'impression à jet d'encre selon la revendication 5, dans lequel la direction qui coupe la direction dans le sens de la longueur des chambres de pression allongées est une direction perpendiculaire à la direction dans le sens de la longueur des chambres de pression allongées.

7. Procédé de fabrication de la tête d'impression à jet d'encre selon la revendication 5, dans lequel la fente de la buse de formation de film a une fente d'une longueur telle qu'une zone de projection formée par l'aérosol projeté par la fente sur le substrat couvre au moins une des chambres de pression.

8. Procédé de fabrication de la tête d'impression à jet d'encre selon la revendication 5, dans lequel la direction qui coupe la direction dans le sens de la longueur des chambres de pression allongées est une direction perpendiculaire à une direction de mouvement relatif dans laquelle le support d'enregistrement se déplace par rapport à la tête d'impression à jet d'encre lorsqu'un enregistrement est exécuté au moyen de la tête d'impression à jet d'encre.

9. Procédé de fabrication de la tête d'impression à jet d'encre selon la revendication 5, dans lequel :
les buses de projection sont agencées de sorte à former, sur le support d'enregistrement, une pluralité de points disposés dans une direction de configuration à une distance d'espacement uniforme ; et
une direction de mouvement relatif dans laquelle la buse de formation de film se déplace par rapport au substrat est la direction de configuration dans laquelle les points sont disposés.

10. Procédé de fabrication de la tête d'impression à jet d'encre selon la revendication 5, dans lequel :
les buses de projection sont agencées au moins dans une direction de configuration ; et
une direction de mouvement relatif dans laquelle la buse de formation de film se déplace par rapport au substrat est la direction de configuration dans laquelle les buses de projection sont agencées.

11. Procédé de fabrication de la tête d'impression à jet d'encre selon la revendication 10, dans lequel :
les buses de projection sont agencées sous la forme d'une matrice dans une première direction de configuration et dans une deuxième direction de configuration qui coupe la première direction de configuration ; et
la direction de mouvement relatif dans laquelle la buse de formation de film se déplace par rapport au substrat est une direction de configuration identique à celle de la première direction de configuration et de la deuxième direction de configuration, dans laquelle des buses de projection parmi les buses de projection sont agencées dans un nombre supérieur à celui des buses de projection qui sont agencées dans l'autre des première et deuxième directions de configuration.

12. Procédé de fabrication de la tête d'impression à jet d'encre selon la revendication 5, dans lequel, dans la projection de l'aérosol, l'aérosol est projeté vers une pluralité de zones de projection, du substrat, qui sont agencées dans une direction de mouvement relatif dans laquelle le support d'enregistrement se déplace par rapport à la tête d'impression à jet d'encre tandis que la buse de formation de film se déplace par rapport à chacune des zones de projection.

13. Procédé de fabrication de la tête d'impression à jet d'encre selon la revendication 5, dans lequel la couche de matériau piézoélectrique est formée sur le substrat sur l'autre surface de celui-ci, sur un côté opposé à l'unité de canal.

14. Procédé de fabrication de la tête d'impression à jet d'encre selon la revendication 5, dans lequel :
la tête d'impression à jet d'encre est une tête d'impression à jet d'encre de type série qui projette de l'encre depuis les buses de projection sur le support d'enregistrement qui est transporté dans une direction de transport perpendiculaire à une direction de balayage prédéterminée tout en se déplaçant dans la direction du balayage ; et
une direction de mouvement relatif dans laquelle la buse de formation de film se déplace par rapport au substrat est la direction de transport dans laquelle le support d'enregistrement est transporté.

15. Procédé de fabrication de la tête d'impression à jet d'encre selon la revendication 5, dans lequel :
la tête d'impression à jet d'encre est une tête d'impression à jet d'encre de type en ligne dont les buses de projection sont agencées à une distance d'espacement uniforme dans une direction de configuration perpendiculaire à une direction de transport dans laquelle le support d'enregistrement est transporté ; et
une direction de mouvement relatif dans laquelle la buse de formation de film se déplace par rapport au substrat est la direction de configuration des buses de projection.

16. Procédé de fabrication d'une imprimante à jet d'encre comprenant la fabrication de la tête d'impression à jet d'encre par le procédé selon la revendication 5 ; et une unité mobile qui déplace la tête d'impression à jet d'encre par rapport au support d'enregistrement dans une direction de mouvement relatif ; le procédé comprenant :
une étape consistant à réaliser la tête d'impression à jet d'encre ; et
une étape consistant à réaliser l'unité mobile ;
dans lequel la plus petite direction dans le sens de la largeur de la fente est une direction qui coupe la direction de mouvement relatif.

17. Procédé de fabrication de l'imprimante à jet d'encre selon la revendication 16, dans lequel la tête d'impression à jet d'encre comprend une pluralité de têtes qui projettent une pluralité d'encres de couleurs différentes respectivement.

18. Tête d'impression à jet d'encre (1) qui projette une encre, comprenant :
une unité de canal (2) comprenant une pluralité de chambres de pression allongées (14) qui sont agencées le long d'un plan, et une pluralité de buses de projection (20) qui communiquent avec les chambres de pression (14) respectivement et qui projettent de l'encre ; et
un actuateur piézoélectrique (3) comprenant un substrat plat (30) disposé sur une surface de l'unité de canal de sorte à couvrir les chambres de pression, et une pluralité de couches minces de film disposées sur une surface du substrat, les couches minces de film comprenant une couche de matériau piézoélectrique (31) ;
dans lequel dans au moins une couche mince de film parmi les couches minces de film, une uniformité d'épaisseur de la couche mince de film dans une direction qui coupe la direction dans le sens de la longueur des chambres de pression allongées est supérieure à une uniformité d'épaisseur de la couche mince de film dans une direction perpendiculaire à la direction de coupe.

19. Tête d'impression à jet d'encre selon la revendication 18, dans laquelle la au moins une couche mince de film est formée en projetant un aérosol qui contient des particules de formation de la couche mince de film et un gaz porteur à travers une fente formée dans une buse de formation de film tout en déplaçant la buse de formation de film qui comporte la fente par rapport au substrat dans une direction qui est une direction plus courte dans le sens de la largeur de la fente et qui est la direction qui coupe la direction prédéterminée.

20. Tête d'impression à jet d'encre selon la revendication 18,
dans laquelle une pluralité de sections actives allongées est définie dans la couche de matériau piézoélectrique ; et
dans au moins une couche mince de film parmi les couches minces de film, une uniformité d'épaisseur de la couche mince de film dans une direction qui coupe une longueur des section actives allongées est supérieure à une uniformité d'épaisseur de la couche mince de film dans une direction perpendiculaire à la direction de coupe.

21. Tête d'impression à jet d'encre selon la revendication 20, dans laquelle la au moins une couche mince de film est formée en projetant un aérosol qui contient des particules de formation de la couche mince de film et un gaz porteur à travers une fente formée dans une buse de formation de film tout en déplaçant la buse de formation de film qui comporte la fente par rapport au substrat dans une direction qui est une direction plus courte dans le sens de la largeur de la fente et qui est la direction de coupe.

22. Tête d'impression à jet d'encre selon la revendication 21, dans laquelle la direction de coupe est une direction perpendiculaire à la direction dans le sens de la longueur des sections actives allongées.

23. Imprimante à jet d'encre pourvue de la tête d'impression à jet d'encre selon la revendication 18, comprenant :
une unité mobile qui déplace la tête d'impression à jet d'encre par rapport au support d'enregistrement dans une direction de mouvement relatif,
dans lequel dans au moins une couche mince de film parmi les couches minces de film, une uniformité d'épaisseur de la couche mince de film dans une direction qui coupe la direction de mouvement relatif est supérieure à une uniformité d'épaisseur de la couche mince de film dans une direction perpendiculaire à la direction de coupe.

24. Imprimante à jet d'encre selon la revendication 23, dans laquelle la au moins une couche mince de film est formée en projetant un aérosol qui contient des particules de formation de la couche mince de film et un gaz porteur à travers une fente formée dans une buse de formation de film tout en déplaçant la buse de formation de film qui comporte la fente par rapport au substrat dans une direction qui est une direction plus courte dans le sens de la largeur de la fente et qui est la direction de coupe.
